# EUROPÄISCHE PATENTSCHRIFT

(11) **EP 2 901 479 B1**
(45) Veröffentlichungstag und Bekanntmachung des Hinweises auf die Patenterteilung: **17.08.2016**
(21) Anmeldenummer: 13763262.6
(22) Anmeldetag: 19.09.2013
(51) Int. Cl.: H01L 25/075, H01L 23/00, H01L 25/00, H01L 33/50, H01L 33/54

(54) **OPTOELEKTRONISCHES BAUELEMENT**
OPTOELECTRONIC COMPONENT
COMPOSANT OPTOÉLECTRONIQUE

(30) Priorität: 27.09.2012 DE 102012217521
(43) Veröffentlichungstag der Anmeldung: 05.08.2015
(73) Patentinhaber: OSRAM Opto Semiconductors GmbH, 93055 Regensburg (DE)
(72) Erfinder: MOOSBURGER, Jürgen, 93055 Regensburg (DE)
(74) Vertreter: Epping - Hermann - Fischer
(86) Internationale Anmeldenummer: PCT/EP2013/069489
(87) Internationale Veröffentlichungsnummer: WO 2014/048830

(56) Entgegenhaltungen:
- EP-A1- 2 216 834
- WO-A1-2010/035206

## Beschreibung

Die Erfindung betrifft ein optoelektronisches Bauelement und ein Verfahren zum Herstellen eines solchen Bauelements. Das optoelektronische Bauelement weist einen Träger, auf dem Träger angeordnete optoelektronische Halbleiterchips, und auf den Halbleiterchips angeordnete Konversionselemente auf. Auf dem Träger ist ferner ein Isolationsmaterial angeordnet, welches die Halbleiterchips und die Konversionselemente umgibt.

Optoelektronische Bauelemente sind in unterschiedlichen Ausführungsformen bekannt. Für Beleuchtungsanwendungen kommen sogenannte SSL Light Engines (Solid State Lighting) zur Anwendung, welche mehrere auf einem Träger bzw. einer Platine angeordnete LED-Chips (Light Emitting Diode) umfassen können (Chip-on-Board). Auf den Halbleiterchips können plättchenförmige Konversionselemente (Phosphore) zum Konvertieren der von den Halbleiterchips abgegebenen Lichtstrahlung angeordnet sein.

In der Druckschrift WO 2010/035206 A1 ist ein Licht emittierendes Bauelement beschrieben, bei dem ein Phosphorkörper auf einer LED angeordnet ist. Auf einer lateralen Oberfläche des Licht emittierenden Bauelements ist eine Beschichtung mit reflektierender Funktionalität angeordnet, so dass das Licht nicht wesentlich über die laterale Oberfläche austreten kann.

In der Druckschrift EP 2 216 834 A1 ist ein Verfahren beschrieben, bei dem Licht emittierende Bauelemente in Flipchip-Technik auf ein Verdrahtungssubstrat aufgebracht werden. Auf die Licht emittierenden Bauelemente wird ein lichtdurchlässiges Element und ein Abdeckelement aufgebracht. Ein Harz wird zur Ausbildung eines Versiegelungselement aufgebracht und mit einer Rakel verteilt.

Im Rahmen der Herstellung der weiter oben genannten optoelektronischen Bauelemente für Beleuchtungsanwendungen wird der Träger nach dem Anordnen der Halbleiterchips und Konversionselemente üblicherweise mit einem weißen Isolationsmaterial vergossen. Dies dient dazu, auf dem Träger befindliche metallische Flächen zu verdecken. Auf diese Weise kann vermieden werden, dass ein in Richtung des Trägers reflektierter Lichtanteil, beispielsweise hervorgerufen durch eine Reflexion an einer Linse des Bauelements, an den metallischen Flächen absorbiert wird.

Bei dem Vergießen wird das Isolationsmaterial in flüssiger bzw. zähflüssiger Form auf den Träger aufgebracht, und werden Bereiche zwischen den Halbleiterchips und um diese herum mit dem Isolationsmaterial aufgefüllt. Damit bei diesem Prozess das Isolationsmaterial nicht über die Konversionselemente läuft und diese überdeckt, sind die Konversionselemente am Rand der Vorderseiten mit wohldefinierten Kanten ausgebildet. An den Vorderkanten kann das Isolationsmaterial aufgrund der Oberflächenspannung gestoppt werden.

Abhängig von der zu erzeugenden Lichtstrahlung kann ein optoelektronisches Bauelement mit unterschiedlichen Konversionselementen aufgebaut werden, welche die von den Halbleiterchips abgegebene Lichtstrahlung in Lichtstrahlungen unterschiedlicher Farben bzw. Wellenlängenbereiche umwandeln. Herstellungsbedingt können unterschiedliche Konversionselemente unterschiedliche Dicken aufweisen. Dies kann zur Folge haben, dass bei den auf einem Träger angeordneten Halbleiterchips die Vorderseiten der verschiedenen Konversionselemente, und damit die hier vorliegenden Kanten, sich in unterschiedlichen Höhen in Bezug auf den Träger befinden. Bei einem Vergießen mit einem Isolationsmaterial kann daher das Problem auftreten, dass das Isolationsmaterial bis zu höher liegenden Vorderkanten von Konversionselementen hin ansteigt, jedoch von niedrigeren Kanten nicht gestoppt wird, und dadurch über die tiefer liegenden Oberflächen der zugehörigen Konversionselemente fließt. Eine Folge hiervon ist eine reduzierte Lichtemission des Bauelements. Dieses Problem kann insbesondere bei relativ eng gesetzten Halbleiterchips auftreten.

Die Aufgabe der vorliegenden Erfindung besteht darin, eine Lösung für ein verbessertes optoelektronisches Bauelement anzugeben.

Diese Aufgabe wird durch die Merkmale der unabhängigen Patentansprüche gelöst. Weitere vorteilhafte Ausführungsformen der Erfindung sind in den abhängigen Ansprüchen angegeben.

Gemäß einem Aspekt der Erfindung wird ein optoelektronisches Bauelement vorgeschlagen. Das optoelektronische Bauelement weist einen Träger, einen auf dem Träger angeordneten ersten optoelektronischen Halbleiterchip, ein auf dem ersten Halbleiterchip angeordnetes erstes Konversionselement zum Konvertieren einer von dem ersten Halbleiterchip abgegebenen Lichtstrahlung, einen auf dem Träger angeordneten zweiten opto-elektronischen Halbleiterchip, und ein auf dem zweiten Halbleiterchip angeordnetes zweites Konversionselement zum Konvertieren einer von dem zweiten Halbleiterchip abgegebenen Lichtstrahlung auf. Das optoelektronische Bauelement weist des Weiteren ein auf dem Träger angeordnetes Isolationsmaterial auf, welches den ersten und zweiten Halbleiterchip und (zum Teil) das erste und zweite Konversionselement umgibt. Das erste Konversionselement ist stufenförmig ausgebildet und weist einen ersten und einen zweiten Abschnitt auf. Der erste Abschnitt steht seitlich über den zweiten Abschnitt hervor.

Das erste Konversionselement kann derart auf dem ersten Halbleiterchip angeordnet sein, dass der erste Abschnitt dem ersten Halbleiterchip gegenüberliegt. Aufgrund der stufenförmigen Ausgestaltung mit dem seitlich über den zweiten Abschnitt hinausragenden ersten Abschnitt kann das erste Konversionselement seitlich am Rand zwei zueinander versetzt vorliegende Kanten bzw. Kantenstrukturen aufweisen. Hierbei handelt es sich um eine am stirn- bzw. vorderseitigen Rand des zweiten Abschnitts vorliegende Kante, und um eine am vorderseitigen Rand des ersten Abschnitts vorliegende weitere, tiefer liegende Kante. Diese zusätzliche Kante des ersten Konversionselements kann im Rahmen der Herstellung des Bauelements ein Stoppen des in flüssiger bzw. zähflüssiger Form durch Vergießen auf den Träger aufgebrachten Isolationsmaterials bewirken, wodurch ein Überdecken des zweiten Konversionselements verhindert werden kann. Insbesondere kann eine Seitenfläche des zweiten Abschnitts frei von dem Isolationsmaterial sein. Das zweite Konversionselement kann ohne Stufenform, und dadurch mit lediglich einer am vorderseitigen Rand vorliegenden Kante bzw. Kantenstruktur ausgebildet sein.

Durch die Stufenform des ersten Konversionselements ist eine Ausgestaltung des Bauelements mit einer größeren Entfernung zwischen dem Träger und der Vorderseite des ersten Konversionselements als zwischen dem Träger und der Vorderseite des zweiten Konversionselements möglich. In dieser Hinsicht kann die zusätzliche Kante des ersten Konversionselements auf gleicher bzw. im Wesentlichen gleicher Höhe liegen wie die vorderseitige Kante des zweiten Konversionselements. Auf diese Weise kann ein Verfüllen mit dem Isolationsmaterial sowohl im Bereich des ersten Halbleiterchips als auch im Bereich des zweiten Halbleiterchips auf gleicher bzw. im Wesentlichen gleicher Höhe gestoppt werden. Im Bereich des ersten Halbleiterchips kann das Stoppen an der zusätzlichen Kante des ersten Konversionselements, und im Bereich des zweiten Halbleiterchips an der Vorderkante des zweiten Konversionselements erfolgen. Das auf den Träger aufgebrachte Isolationsmaterial kann die Halbleiterchips und zum Teil die Konversionselemente daher derart umgeben, dass kein Überdecken der Vorderseite des zweiten Konversionselements auftritt. Weiterhin kann der zweite Abschnitt des ersten Konversionselements in Schnittansicht vollständig aus dem Isolationsmaterial herausragen.

Bei den optoelektronischen Halbleiterchips kann es sich insbesondere um Leuchtdioden- bzw. LED-Chips handeln. Des Weiteren können der erste und zweite Halbleiterchip den gleichen bzw. identischen Aufbau aufweisen. In dieser Hinsicht bezieht sich die Bezeichnung "erster" und "zweiter" Halbleiterchip auf die Zuordnung zu dem dazugehörigen ersten und zweiten Konversionselement. Möglich ist es jedoch auch, dass der erste und zweite Halbleiterchip unterschiedlich aufgebaut sind, und voneinander abweichende Formen und/oder Strukturen besitzen.

Das optoelektronische Bauelement kann insbesondere mit mehreren ersten Halbleiterchips und hierauf angeordneten ersten stufenförmigen Konversionselementen und/oder mehreren zweiten Halbleiterchips und hierauf angeordneten zweiten Konversionselementen ohne Stufenform ausgebildet sein. Hierbei kann die zusätzliche, an ersten Konversionselementen vorliegende Stoppkante im Rahmen des Vergießens des Isolationsmaterials in der oben beschriebenen Weise ein Überdecken der Vorderseiten von zweiten Konversionselementen mit dem Isolationsmaterial verhindern. Dadurch ist eine Positionierung der Halbleiterchips auf dem Träger mit relativ kleinen Abständen, beispielsweise im Bereich von mehreren zehn Mikrometern, zum Beispiel fünfzig Mikrometern, möglich. Die ersten und zweiten Halbleiterchips können wie vorstehend beschrieben den gleichen bzw. einen übereinstimmenden Aufbau aufweisen, sowie zum Abgeben einer Lichtstrahlung des gleichen Spektralbereichs ausgebildet sein. Die ersten und zweiten Konversionselemente können aus unterschiedlichen Konversionsmaterialien ausgebildet sein, um die von den Halbleiterchips abgegebene Lichtstrahlung in Lichtstrahlungen unterschiedlicher Wellenlängenbereiche umwandeln.

Die im Folgenden beschriebenen Ausgestaltungen können bei einer solchen "mehrzahligen" Ausführungsform des Bauelements in gleicher Weise zur Anwendung kommen.

In einer weiteren Ausführungsform weisen das erste und zweite Konversionselement unterschiedliche Dicken auf. Das Vorliegen unterschiedlicher Dicken kann zum Beispiel von einer Herstellung der Konversionselemente aus unterschiedlichen Konversionsmaterialien herrühren. Trotz der unterschiedlichen Dicken bietet die stufenförmige Ausgestaltung des ersten Konversionselements die Möglichkeit, ein Bedecken des zweiten Konversionselements in der oben beschriebenen Weise zuverlässig zu verhindern. Die Konversionselemente können folglich unabhängig voneinander, und im Hinblick auf vorgegebene optische Eigenschaften hin ausgebildet und optimiert sein.

Die vorteilhafte Wirkung der Stufenform des ersten Konversionselements kann nicht nur bei Vorliegen unterschiedlicher Dicken der Konversionselemente zum Tragen kommen. Beispielsweise können (zusätzlich oder alternativ) der erste und zweite Halbleiterchip unterschiedliche Dicken aufweisen. Für diesen Fall kann die zusätzliche Kante des ersten Konversionselements ebenfalls ein Überdecken des zweiten Konversionselements mit dem Isolationsmaterial verhindern.

In einer weiteren Ausführungsform steht der erste Abschnitt des ersten Konversionselements über den gesamten Umfang des ersten Konversionselements seitlich über den zweiten Abschnitt hervor. Hierdurch kann das erste Konversionselement eine den gesamten Umfang umlaufende, und mehrere Kantenabschnitte umfassende Kante bzw. Kantenstruktur aufweisen, welche zum Stoppen des Isolationsmaterials geeignet ist. Dadurch kann ein Überdecken der Vorderseite des zweiten Konversionselements mit dem Isolationsmaterial mit einer hohen Zuverlässigkeit vermieden werden.

In einer weiteren Ausführungsform ist das Isolationsmaterial weißes Silikon. Hierbei handelt es sich um Silikon, welches mit geeigneten Partikeln bzw. Streupartikeln, beispielsweise aus Titanoxid, gefüllt ist. Durch das weiße Silikon können Bereiche zwischen den Halbleiterchips und um die Halbleiterchips herum, und dadurch in diesen Bereichen befindliche metallische Flächen des Trägers, abgedeckt werden, so dass eine Absorption eines reflektierten Lichtanteils vermieden werden kann. Stattdessen kann dieser Lichtanteil an dem weißen Silikon rückreflektiert werden. Die Verwendung von Silikon ermöglicht ein zuverlässiges Vergießen des Trägers.

Anstelle von weißem Silikon kann gegebenenfalls ein anderes reflektives Isolations- bzw. Vergussmaterial zur Anwendung kommen. Ein mögliches Beispiel ist ein Epoxidmaterial, welches in gleicher Weise mit geeigneten Partikeln gefüllt sein kann.

Das Isolationsmaterial kann des Weiteren als Träger von Kontaktstrukturen zum Kontaktieren der Halbleiterchips dienen. In dieser Hinsicht ist gemäß einer weiteren Ausführungsform vorgesehen, dass der erste und zweite Halbleiterchip jeweils wenigstens einen Vorderseitenkontakt aufweisen. Bei dem Bauelement können die Vorderseitenkontakte von dem Isolationsmaterial bedeckt sein. Das Bauelement weist ferner eine auf dem Isolationsmaterial angeordnete Kontaktstruktur auf, welche sich zu wenigstens einem Vorderseitenkontakt erstreckt. Dabei kann die Kontaktstruktur zum Teil in das Isolationsmaterial eingebettet sein.

Mit Hilfe einer solchen Kontaktstruktur, von welcher bei dem Bauelement mehrere vorhanden sein können, kann zum Beispiel ein Vorderseitenkontakt an eine Kontaktfläche des Trägers angeschlossen sein. Hierbei erstreckt sich die betreffende Kontaktstruktur nicht nur durch das Isolationsmaterial hindurch zu dem Vorderseitenkontakt, sondern zusätzlich zu der Kontaktfläche. Möglich ist es auch, Vorderseitenkontakte von zwei Halbleiterchips bzw. des ersten und zweiten Halbleiterchips mit Hilfe der Kontaktstruktur elektrisch miteinander zu verbinden.

Bei Vorliegen lediglich eines Vorderseitenkontakts können der erste und zweite Halbleiterchip des Weiteren jeweils einen Rückseitenkontakt aufweisen. Möglich ist auch eine Ausgestaltung mit zwei Vorderseitenkontakten pro Halbleiterchip. Über die Kontakte kann ein elektrischer Strom an die Halbleiterchips angelegt werden, wodurch die Halbleiterchips eine Lichtstrahlung abgeben. Im Hinblick auf die Vorderseitenkontakte können das erste und zweite Konversionselement hierauf abgestimmt jeweils wenigstens eine entsprechende seitliche Aussparung aufweisen.

Bei dem optoelektronischen Bauelement kann es sich zum Beispiel um eine Weißlichtquelle handeln. In dieser Hinsicht ist gemäß einer weiteren Ausführungsform vorgesehen, dass der erste und zweite Halbleiterchip ausgebildet sind, eine Lichtstrahlung im blauen Spektralbereich zu erzeugen. Eines der beiden Konversionselemente (erstes oder zweites Konversionselement) ist dazu ausgebildet, einen Teil der von einem Halbleiterchip erzeugten blauen Lichtstrahlung in eine Lichtstrahlung im grünen Spektralbereich umzuwandeln. Die blaue und die grüne Lichtstrahlung können zusammen eine mintfarbene Lichtstrahlung ergeben. Das andere der beiden Konversionselemente (zweites oder erstes Konversionselement) ist dazu ausgebildet, die von einem Halbleiterchip erzeugte blaue Lichtstrahlung in eine Lichtstrahlung im roten Spektralbereich umzuwandeln. Die mintfarbene und rote Lichtstrahlung können zu einer weißen bzw. warmweißen Lichtstrahlung überlagert werden.

Eine Weißlichtquelle kann insbesondere mit einer Mehrzahl an solchen lichtemittierenden Einheiten aus Halbleiterchips und Konversionselementen zum Erzeugen von Lichtstrahlungen der Farben Mint und Rot ausgebildet sein. Auf diese Weise kann das betreffende Bauelement eine Lichtstrahlung mit einer Farbtemperatur im warmweißen Bereich und mit hohem Farbwiedergabeindex (CRI, Colour Rendering Index) erzeugen. Zu diesem Zweck können die unterschiedlichen lichtemittierenden Einheiten relativ nah, und in geeigneter Weise verteilt auf dem Träger angeordnet sein.

Für das optoelektronische Bauelement kann ferner eine Ausgestaltung mit (wenigstens) einem Halbleiterchip in Betracht kommen, dessen Lichtstrahlung keiner Konversion unterzogen wird. In dieser Hinsicht ist gemäß einer weiteren Ausführungsform vorgesehen, dass das optoelektronische Bauelement einen weiteren, auf dem Träger angeordneten Halbleiterchip und ein auf dem weiteren Halbleiterchip angeordnetes strahlungsdurchlässiges Element aufweist. Das strahlungsdurchlässige Element dient als Abstandshalter, um ein Überdecken beim Vergießen des Isolationsmaterials in diesem Bereich zu verhindern. Hierfür kann das strahlungsdurchlässige Element zum Beispiel die gleiche Dicke wie das zweite Konversionselement aufweisen. Der weitere Halbleiterchip kann den gleichen bzw. identischen Aufbau aufweisen wie der erste und zweite Halbleiterchip. Möglich ist jedoch auch eine Ausgestaltung mit unterschiedlichen Formen bzw. Strukturen von Halbleiterchips.

In einer weiteren Ausführungsform sind das erste und zweite Konversionselement keramische Konversionselemente. Auf diese Weise kann eine effiziente Wärmeabführung im Betrieb des optoelektronischen Bauelements ermöglicht werden. Ein weiterer möglicher Vorteil besteht darin, dass eine Lichtstreuung (weitgehend) vermieden werden kann.

Gemäß einem weiteren Aspekt der Erfindung wird ein Verfahren zum Herstellen eines optoelektronischen Bauelements vorgeschlagen. Das Bauelement kann entsprechend einer der vorstehend beschriebenen Ausführungsformen hergestellt werden. Das Verfahren umfasst ein Anordnen eines ersten und zweiten optoelektronischen Halbleiterchips auf einem Träger, ein Anordnen eines ersten Konversionselements auf dem ersten Halbleiterchip zum Konvertieren einer von dem ersten Halbleiterchip abgegebenen Lichtstrahlung, und ein Anordnen eines zweiten Konversionselements auf dem zweiten Halbleiterchip zum Konvertieren einer von dem zweiten Halbleiterchip abgegebenen Lichtstrahlung. Weiter vorgesehen ist ein Aufbringen eines Isolationsmaterials auf den Träger derart, dass das Isolationsmaterial den ersten und zweiten Halbleiterchip und das erste und zweite Konversionselement umgibt. Das erste, auf dem ersten Halbleiterchip angeordnete Konversionselement ist stufenförmig ausgebildet und weist einen ersten und einen zweiten Abschnitt auf. Der erste Abschnitt steht seitlich über den zweiten Abschnitt hervor.

Durch die stufenförmige Ausgestaltung mit dem seitlich gegenüber dem zweiten Abschnitt auskragenden ersten Abschnitt kann das erste Konversionselement neben einer am Rand des zweiten Abschnitts befindlichen Vorderkante eine hierzu höhenversetzt bzw. tiefer vorliegende zusätzliche Kante am vorderseitigen Rand des ersten Abschnitts aufweisen. An der zusätzlichen Kante kann das Isolationsmaterial bei einem im Rahmen des Aufbringens auf den Träger durchgeführten Vergießen gestoppt werden. Dadurch ist es möglich, bei Vorliegen unterschiedlicher Höhen bzw. Abstände der Vorderseiten der Konversionselemente in Bezug auf den Träger ein Überdecken der Vorderseite des zweiten Konversionselements zu verhindern.

Das eigentliche Aufbringen des Isolationsmaterials auf den Träger kann wie oben angedeutet in (zäh-)flüssiger Form durch Vergießen bzw. Verfüllen erfolgen. Hieran anschließend kann ein Trocken bzw. Aushärten des Isolationsmaterials durchgeführt werden. Dies kann bei einer entsprechenden Temperatur, zum Beispiel 150°C, erfolgen.

Das erste Konversionselement kann durch Durchführen eines zweistufigen Strukturierungsverfahrens aus einem Ausgangselement erzeugt werden. In einer ersten Stufe kann die Struktur des zweiten Abschnitts auf bzw. in dem Ausgangselement ausgebildet werden. In einer nachfolgenden zweiten Stufe kann sowohl die Struktur des ersten Abschnitts ausgebildet, als auch das gesamte erste Konversionselement vereinzelt werden. Die einzelnen Strukturierungsprozesse können zum Beispiel Sägeprozesse oder Laserprozesse umfassen. In einer weiteren Ausführungsform weisen der erste und zweite Halbleiterchip jeweils wenigstens einen Vorderseitenkontakt auf. Hierbei werden die Vorderseitenkontakte von dem auf den Träger aufgebrachten Isolationsmaterial überdeckt. Zum Ermöglichen eines Kontaktierens eines Vorderseitenkontakts wird eine an den Vorderseitenkontakt heranreichende Aussparung in dem Isolationsmaterial ausgebildet. Nach dem Ausbilden der Aussparung wird ein metallisches Material unter Auffüllen der Aussparung auf das Isolationsmaterial aufgebracht, um eine Kontaktstruktur auszubilden.

Für das Herstellungsverfahren können oben zu dem optoelektronischen Bauelement angegebene Ausführungsformen und Aspekte in gleicher Weise in Betracht kommen.

Die vorstehend erläuterten und/oder in den Unteransprüchen wiedergegebenen vorteilhaften Aus- und Weiterbildungen der Erfindung können - außer zum Beispiel in Fällen eindeutiger Abhängigkeiten oder unvereinbarer Alternativen - einzeln oder aber auch in beliebiger Kombination miteinander zur Anwendung kommen.

Die oben beschriebenen Eigenschaften, Merkmale und Vorteile dieser Erfindung sowie die Art und Weise, wie diese erreicht werden, werden klarer und deutlicher verständlich in Zusammenhang mit der folgenden Beschreibung von Ausführungsbeispielen, die im Zusammenhang mit den schematischen Zeichnungen näher erläutert werden. Es zeigen:
Figuren 1 bis 4 ein Verfahren zur Herstellung eines optoelektronischen Bauelements umfassend optoelektronische Halbleiterchips und auf den Halbleiterchips angeordnete Konversionselemente mit und ohne Stufenform, jeweils in einer schematischen seitlichen Darstellung;
Figur 5 ein dazugehöriges Ablaufdiagramm eines Verfahrens zur Herstellung eines optoelektronischen Bauelements;
Figuren 6 bis 8 ein Verfahren zur Herstellung stufenförmiger Konversionselemente, jeweils in einer schematischen perspektivischen Darstellung;
Figur 9 eine schematische seitliche Darstellung eines optoelektronischen Bauelements, welches Halbleiterchips mit unterschiedlichen Dicken aufweist;
Figur 10 eine schematische seitliche Darstellung eines optoelektronischen Bauelements, bei welchem Vorder- und Rückseitenkontakte von Halbleiterchips elektrisch verbunden sind;
Figur 11 eine schematische seitliche Darstellung eines optoelektronischen Halbleiterchips mit einem Vorderseitenkontakt, einem Rückseitenkontakt und einer Durchkontaktierung;
Figur 12 eine schematische seitliche Darstellung eines optoelektronischen Bauelements, bei welchem in abwechselnder Weise jeweils Vorderseitenkontakte und jeweils Rückseitenkontakte von Halbleiterchips elektrisch verbunden sind;
Figur 13 eine schematische seitliche Darstellung eines optoelektronischen Halbleiterchips mit einem Vorderseiten- und einem Rückseitenkontakt;
Figur 14 eine schematische seitliche Darstellung eines optoelektronischen Bauelements umfassend Halbleiterchips mit zwei Vorderseitenkontakten, wobei Vorderseitenkontakte von Halbleiterchips elektrisch verbunden sind;
Figur 15 eine schematische seitliche Darstellung eines optoelektronischen Halbleiterchips mit zwei Vorderseitenkontakten und einer Durchkontaktierung;
Figur 16 eine schematische Aufsichtsdarstellung einer Anordnung aus Halbleiterchips und Konversionselementen eines optoelektronischen Bauelements;
Figur 17 eine schematische Aufsichtsdarstellung eines optoelektronischen Halbleiterchip mit einem auf dem Halbleiterchip angeordneten stufenförmigen Konversionselement; und
Figur 18 eine schematische seitliche Darstellung eines optoelektronischen Bauelements, welches Halbleiterchips mit auf den Halbleiterchips angeordneten Konversionselementen und einen weiteren Halbleiterchip mit einem hierauf angeordneten strahlungsdurchlässigen Element umfasst.

Auf der Grundlage der folgenden schematischen Figuren werden Ausführungsformen eines optoelektronischen Bauelements und eines dazugehörigen Verfahrens zur Herstellung beschrieben. Es wird darauf hingewiesen, dass die Figuren nicht maßstabsgetreu sind, so dass hier gezeigte Komponenten und Strukturen zum besseren Verständnis übertrieben groß oder verkleinert dargestellt sein können. Die erläuterten Bauelemente weisen mehrere optoelektronische Halbleiterchips und hierauf angeordnete Konversionselemente zum Konvertieren einer von den Halbleiterchips abgegebenen Lichtstrahlung auf. Die für Beleuchtungsanwendungen einsetzbaren Bauelemente, welche als Chipmodul, SSL Light Engine oder Multichip Light Engine bezeichnet werden können, sind dahingehend ausgebildet, ein Überdecken von Vorderseiten von Konversionselementen bei einem Vergießen eines Isolationsmaterials zu verhindern. Die Bauelemente können in Form von Weißlichtquellen verwirklicht sein, welche im Betrieb eine weiße, insbesondere warmweiße Lichtstrahlung mit hohem Farbwiedergabeindex abgeben.

Im Rahmen der Herstellung können aus der Halbleitertechnik und aus der Fertigung optoelektronischer Bauelemente bekannte Prozesse durchgeführt werden sowie übliche Materialien zum Einsatz kommen, so dass hierauf nur teilweise eingegangen wird. Es wird ferner darauf hingewiesen, dass neben dargestellten und beschriebenen Prozessen gegebenenfalls weitere Verfahrensschritte zum Vervollständigen eines Bauelements durchgeführt werden können. In gleicher Weise können die erläuterten Bauelemente neben gezeigten und beschriebenen Strukturen weitere Strukturen, Strukturelemente und/oder Schichten umfassen.

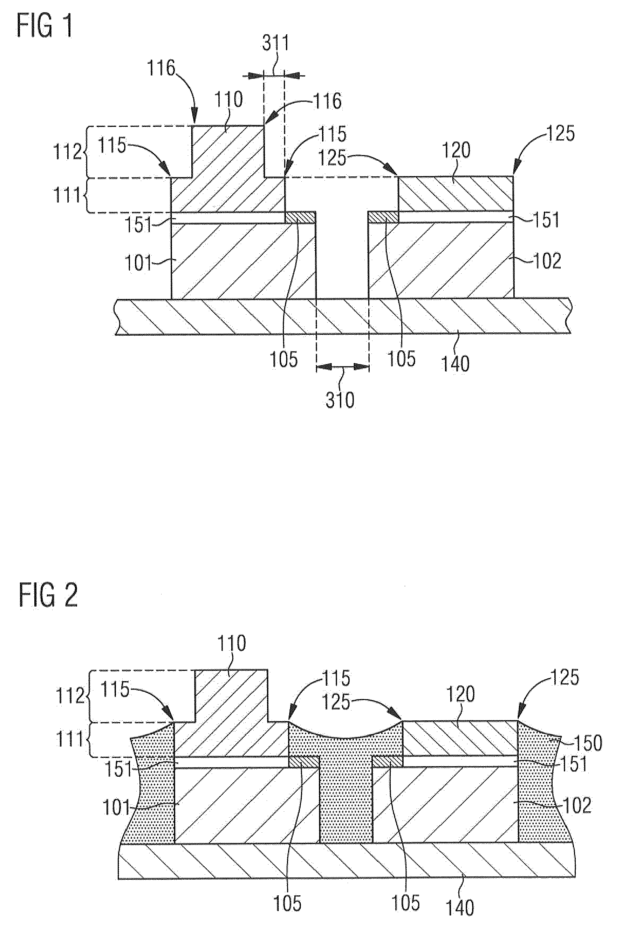

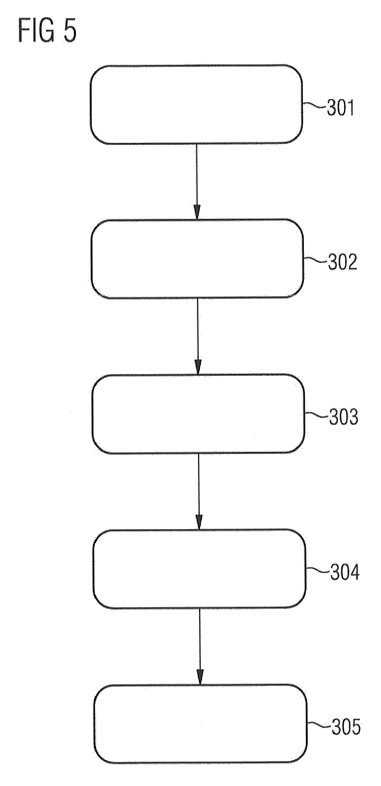

Anhand der Figuren 1 bis 4 wird die Herstellung eines ersten optoelektronischen Bauelements 201 beschrieben. Bei dem Verfahren durchgeführte Verfahrensschritte sind ergänzend in dem Ablaufdiagramm von Figur 5 zusammengefasst, auf welches im Folgenden ebenfalls Bezug genommen wird.

Bei dem Verfahren werden in einem Schritt 301 (vgl. Figur 5) zunächst in Figur 1 gezeigte Bestandteile des Bauelements 201 bereitgestellt. Hierunter fallen optoelektronische Halbleiterchips 101, 102, Konversionselemente 110, 120 zum Anordnen auf den Halbleiterchips 101, 102, und ein Träger 140. In Figur 1, und auch in den folgenden Figuren 2 bis 4, sind lediglich zwei Halbleiterchips 101, 102 und dazugehörige Konversionselemente 110, 120 dargestellt. Diese Bauteile werden zum Ermöglichen einer besseren Zuordnung und Unterscheidung im Folgenden auch als erster Halbleiterchip 101 und zweiter Halbleiterchip 102, sowie als erstes Konversionselement 110 und zweites Konversionselement 120 bezeichnet.

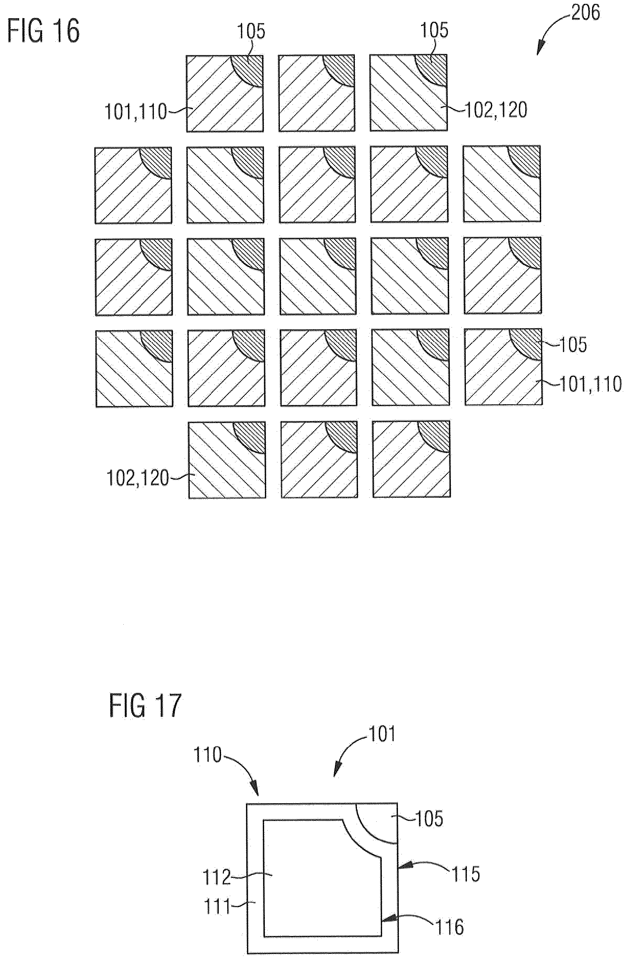

Es ist möglich, dass das optoelektronische Bauelement 201 mit mehreren ersten Halbleiterchips 101 und ersten Konversionselementen 110 und/oder mit mehreren zweiten Halbleiterchips 102 und zweiten Konversionselementen 120 verwirklicht wird (vgl. hierzu die in Figur 16 gezeigte Ausführungsform). In dieser Hinsicht können sich die Figuren 1 bis 4 lediglich auf einen Teilausschnitt des herzustellenden Bauelements 201 beziehen. Die folgende Beschreibung anhand der gezeigten zwei Halbleiterchips 101, 102 und Konversionselemente 110, 120 kann daher in gleicher Weise für eine "mehrzahlige" Ausgestaltung zutreffen.

Bei den optoelektronischen Halbleiterchips 101, 102 kann es sich insbesondere um Leuchtdioden- bzw. LED-Chips handeln. Die Halbleiterchips 101, 102 sind dazu ausgebildet, im Betrieb bei Anlegen eines elektrischen Stroms eine Lichtstrahlung abzugeben. Im Hinblick auf eine Ausgestaltung des Bauelements 201 als Weißlichtquelle können die Halbleiterchips 101, 102 zum Abgeben einer Lichtstrahlung im blauen Wellenlängenbereich ausgebildet sein. Zu diesem Zweck können die Halbleiterchips 101, 102 zum Beispiel eine Halbleiterschichtenfolge basierend auf einem III/V-Verbindungshalbleiterma-terial, beispielsweise InGaN oder GaN, aufweisen. Es ist möglich, dass die Halbleiterchips 101, 102 den gleichen bzw. einen vergleichbaren Aufbau sowie, wie in Figur 1 angedeutet, die gleiche Höhe bzw. Dicke besitzen.

Für das Anlegen eines elektrischen Stroms sind die in Figur 1 gezeigten Halbleiterchips 101, 102 sowohl an einer Vorderseite als auch an einer der Vorderseite entgegen gesetzten Rückseite kontaktierbar. Im Bereich der Vorderseite weisen die Halbleiterchips 101, 102 jeweils einen metallischen Kontakt 105 auf. Die Vorderseitenkontakte 105, welche in Form von Kontaktflächen vorliegen können, sind am Rand (bzw. an einer Ecke, vgl. Figur 16) der Halbleiterchips 101, 102 angeordnet. Über die Vorderseite wird des Weiteren die von den Halbleiterchips 101, 102 erzeugte Lichtstrahlung emittiert (Lichtaustrittsseite). An der Rückseite weisen die Halbleiterchips 101, 102 metallische Rückseitenkontakte auf (nicht dargestellt in Figur 1).

Die den Halbleiterchips 101, 102 zugeordneten Konversionselemente 110, 120 werden zum Konvertieren der von den Halbleiterchips 101, 102 abgegebenen Lichtstrahlung eingesetzt. Die Konversionselemente 110, 120 sind dazu ausgebildet, die von den Halbleiterchips 101, 102 über deren Vorderseiten abgegebene primäre Lichtstrahlung (jeweils) in eine sekundäre Lichtstrahlung eines anderen Wellenlängenbereichs umzuwandeln. Hierbei weichen die Spektralbereiche der Sekundärstrahlungen der verschiedenen Konversionselemente 110, 120 voneinander ab.

Im Hinblick auf die Ausgestaltung des Bauelements 201 als Weißlichtquelle kann vorgesehen sein, einen Teil der blauen Primärstrahlung des ersten Halbleiterchips 101 mit dem ersten Konversionselement 110 in eine Sekundärstrahlung im grünen Wellenlängenbereich umzuwandeln (Teilkonversion). Die blaue und die grüne Lichtstrahlung können zusammen eine mintfarbene Lichtstrahlung ergeben. In Bezug auf den zweiten Halbleiterchip 102 kann vorgesehen sein, dass das zweite Konversionselement 120 im Wesentlichen die gesamte blaue Primärstrahlung in eine sekundäre Lichtstrahlung im roten Wellenlängenbereich umwandelt (Vollkonversion). Die mintfarbene und die rote Lichtstrahlung können, insbesondere bei Vorliegen einer Mehrzahl lichtemittierender Einheiten aus Halbleiterchips 101 und Konversionselementen 110 und lichtemittierender Einheiten aus Halbleiterchips 102 und Konversionselementen 120, zu einer weißen bzw. warmweißen Lichtstrahlung überlagert werden. Möglich ist auch eine umgekehrte Ausgestaltung, d.h. dass das erste Konversionselement 110 zum Erzeugen einer roten, und das zweite Konversionselement 120 zum Erzeugen einer grünen Lichtstrahlung ausgebildet sind.

Die die Primärstrahlung der Halbleiterchips 101, 102 in verschiedene Sekundärstrahlungen konvertierenden Konversionselemente 110, 120 sind aus unterschiedlichen Materialien aufgebaut. Dies kann herstellungsbedingt, insbesondere im Hinblick auf eine optimale Herstellung der jeweiligen Konversionselemente 110, 120, zu einem Vorliegen unterschiedlicher Dicken der Konversionselemente 110, 120 führen. Wie in Figur 1 gezeigt ist, weist das erste Konversionselement 110 eine größere Dicke als das zweite Konversionselement 120 auf. Die Dicken der Konversionselemente 110, 120 können zum Beispiel im Bereich von mehreren zehn bis zu mehreren hundert Mikrometern liegen.

Um trotz der unterschiedlichen Dicken ein Überdecken des dünneren zweiten Konversionselements 120 durch ein in einem späteren Verfahrensstadium aufgebrachtes Isolationsmaterial 150 zu verhindern, ist das dickere erste Konversionselement 110 im Querschnitt stufenförmig ausgebildet. Das erste Konversionselement 110 weist wie in Figur 1 gezeigt einen ersten Abschnitt 111 und einen zweiten Abschnitt 112 mit gegenüber dem ersten Abschnitt 111 kleineren lateralen Abmessungen auf. Der erste Abschnitt 111, mit welchem das erste Konversionselement 110 mit dem ersten Halbleiterchip 101 verbunden wird, steht auf diese Weise seitlich über den zweiten Abschnitt 112 hervor. Beim späteren Aufbringen des Isolationsmaterials bleibt eine Seitenfläche des zweiten Abschnitts frei von dem Isolationsmaterial.

Auf diese Weise besitzt das erste Konversionselement 110 eine am vorderseitigen Rand des zweiten Abschnitts 112 vorliegende Kantenstruktur 116, und hierzu versetzt bzw. tiefer eine am vorderseitigen Rand des ersten Abschnitts 111 vorliegende Kantenstruktur 115. Die stufenförmige Ausgestaltung des ersten Konversionselements 110 mit dem seitlich über den zweiten bzw. oberen Abschnitt 112 hinausragenden ersten bzw. unteren Abschnitt 111 liegt über den gesamten Umfang des ersten Konversionselements 110 vor. Hierdurch umlaufen die zwei Kantenstrukturen 115, 116 jeweils den gesamten Umfang des stufenförmigen Konversionselements 110.

Die zwei Kantenstrukturen 115, 116 können, von oben betrachtet, aus mehreren aneinander grenzenden Kantenabschnitten zusammengesetzt sein (vgl. die in Figur 17 gezeigte Ausführungsform mit vier geraden Abschnitten und einem gekrümmten Abschnitt pro Kantenstruktur 115, 116). Hierbei ist die Kantenstruktur 116 gegenüber der Kantenstruktur 115 lateral nach innen versetzt. Anhand von Figur 1 wird deutlich, dass das erste Konversionselement 110 im Bereich der beiden Kantenstrukturen 115, 116 jeweils eine rechtwinklige Querschnittsform besitzt.

Das zweite, auf dem zweiten Halbleiterchip 102 verwendete Konversionselement 120 weist demgegenüber (im Querschnitt) keine Stufenform auf. Daher besitzt das zweite Konversionselement vorderseitig am Rand lediglich eine umfangsseitig umlaufende Kantenstruktur 125, welche von oben betrachtet ebenfalls aus mehreren aneinander grenzenden Kantenabschnitten zusammengesetzt sein kann (vgl. Figur 16). Im Bereich der Kantenstruktur 125 liegt, wie in Figur 1 gezeigt, ebenfalls eine rechtwinklige Querschnittsform vor. Die Kantenstrukturen 115, 116, 125 des ersten und zweiten Konversionselements 110, 120 werden im Folgenden in verkürzter Form auch lediglich mit dem Ausdruck "Kante" bezeichnet.

Bei den Konversionselementen 110, 120 kann es sich zum Beispiel um keramische Konversionselemente handeln. Auf diese Weise kann der Vorteil einer effizienten Wärmeabführung im Betrieb des optoelektronischen Bauelements 201 ermöglicht werden. Ein weiterer Vorteil besteht darin, dass keine oder nur eine relativ kleine Lichtstreuung auftritt. Das Herstellen der in keramischer Form vorliegenden Konversionselemente 110, 120 kann ein Sintern eines zunächst in Pulverform vorliegenden Konversionsmaterials umfassen.

Für die Konversion einer blauen in eine grüne Lichtstrahlung kann als Konversionsmaterial zum Beispiel ein mit Cerium dotiertes Granat, beispielsweise YAG (Yttrium-Aluminium-Granat) oder LuAG (Lutetium-Aluminium-Granat), verwendet werden. Möglich ist auch LuYAG mit Mischverhältnissen zwischen Yttrium und Lutetium. Optional ist die Beigabe von Gallium oder Gadolinium möglich, und kann Aluminium durch Magnesium ersetzt werden. Ferner kann anstelle von Cerium eine Dotierung mit Europium vorgesehen sein. Weitere in Betracht kommende Materialien sind SrSiON oder BaSiON, jeweils mit Europium dotiert.

Für die Konversion einer blauen in eine rote Lichtstrahlung kann zum Beispiel mit Europium dotiertes CaAlSiN verwendet werden. Möglich ist ferner die Verwendung von zum Beispiel Europium dotiertem (EA)2Si5N8, wobei EA für ein Erdalkalimetall wie zum Beispiel Sr, Ba, Ca oder Mischungen hiervon steht.

Für die Grünkonversion kann eine Dicke bzw. Schichtdicke eines keramischen Konversionselements beispielsweise im Bereich zwischen 30 und 600 Mikrometern liegen. Für die Rotkonversion kann eine Dicke beispielsweise im Bereich zwischen 30 und 300 Mikrometern vorliegen.

Alternativ können auch andere Ausführungsformen für die Konversionselemente 110, 120 in Betracht kommen. Beispielsweise ist es möglich, die Konversionselemente 110, 120 aus Silikon auszubilden, wobei das Silikon mit Partikeln eines Konversionsmaterials gefüllt ist. Die Partikel können zum Beispiel aus den vorstehend angegebenen Konversionsmaterialien ausgebildet sein. Aus partikelgefülltem Silikon ausgebildete Konversionselemente können Dicken im Bereich von zum Beispiel 20 bis 300, beispielsweise 30 bis 80 Mikrometern, aufweisen.

Der Träger 140, welcher zum Tragen der Halbleiterchips 101, 102 vorgesehen ist, kann mit (nicht dargestellten) Anschluss- bzw. Kontaktstrukturen für die Halbleiterchips 101, 102 ausgebildet sein. Beispielsweise kann der Träger 140 auf Rückseitenkontakte der Halbleiterchips 101, 102 abgestimmte metallische Gegenkontakte umfassen. Der Träger 140 kann des Weiteren zum Beispiel in Form eines keramischen Trägers ausgebildet sein. Alternativ kann eine andere Ausgestaltung in Betracht kommen. Beispielsweise kann der Träger 140 eine (nicht dargestellte) metallische Wärmesenke aufweisen, wobei die Wärmesenke, sowie zum Teil entsprechende Anschluss- bzw. Kontaktstrukturen, von einem Kunststoffmaterial umgeben sind (Premold-Träger).

Nach dem Bereitstellen (Schritt 301) werden die einzelnen Bestandteile des herzustellenden Bauelements 201 in einem weiteren Schritt 302 entsprechend der in Figur 1 gezeigten Anordnung zusammengebaut. Dabei werden die Halbleiterchips 101, 102 auf dem Träger 140, und werden die Konversionselemente 110, 120 auf den Halbleiterchips 101, 102 angeordnet. Hierbei kann zuerst das Anordnen der Chips 101, 102 auf dem Träger 140, gefolgt von dem Anordnen der Konversionselemente 110, 120 auf den Chips 101, 102, durchgeführt werden.

Das Anordnen der Halbleiterchips 101, 102 auf dem Träger 140 kann zum Beispiel durch Löten unter Verwendung eines Lotmittels erfolgen. Auf diese Weise können die Rückseitenkontakte der Halbleiterchips 101, 102 und Gegenkontakte des Trägers 140 elektrisch und mechanisch verbunden werden.

Die Halbleiterchips 101, 102 werden wie in Figur 1 gezeigt in einem Abstand 310 zueinander auf dem Träger 140 angeordnet. Der Abstand 310 kann relativ klein sein, und zum Beispiel fünfzig Mikrometer betragen. Im Hinblick auf eine "mehrzahlige" Ausgestaltung des Bauelements 201 kann zwischen sämtlichen Halbleiterchips 101, 102 übereinstimmend der gleiche Abstand 310 vorliegen, und können diese in geeigneter Weise verteilt auf dem Träger 140 angeordnet werden (vgl. die Ausführungsform von Figur 16).

Die Halbleiterchips 101, 102 können des Weiteren mit einer entsprechenden Orientierung auf dem Träger 140 angeordnet werden, welche auf eine in einem späteren Verfahrensstadium hergestellte elektrische Kontaktierung der Chips 101, 102 abgestimmt ist. Bei den in Figur 1 gezeigten zwei Halbleiterchips 101, 102 ist vorgesehen, die Vorderseitenkontakte 105 elektrisch miteinander zu verbinden. Hierzu können die Halbleiterchips 101, 102, wie in Figur 1 dargestellt, mit den die Kontakte 105 aufweisenden Chipbereichen bzw. Chipseiten einander zugewandt sein. Möglich sind jedoch auch andere Chiporientierungen.

Die Konversionselemente 110, 120 werden wie in Figur 1 gezeigt unter Verwendung eines durchsichtigen Klebstoffs 151 mit den Halbleiterchips 101, 102 verbunden. Als Klebstoff 151 kommt zum Beispiel die Verwendung eines Silikonklebers in Betracht. Die Konversionselemente 110, 120 werden derart auf den Halbleiterchips 101, 102 bzw. auf deren Vorderseiten positioniert, dass die Vorderseitenkontakte 105 freiliegen. In dieser Hinsicht weisen die Konversionselemente 110, 120 eine auf die Halbleiterchips 101, 102 abgestimmte Form mit einer am Rand vorliegenden Aussparung auf. Die Konversionselemente 110, 120 können insbesondere, von oben betrachtet, eine im Wesentlichen rechteckige bzw. quadratische Grundform mit einer Aussparung an einer Ecke besitzen (vgl. Figur 16). In Bezug auf das stufenförmige erste Konversionselement 110 weisen dessen beide Abschnitte 111, 112 eine vergleichbare Kontur (d.h. mit einer solchen Aussparung) auf, so dass die Stufenform wie oben beschrieben über den gesamten Umfang des ersten Konversionselements 110 vorliegen kann (vgl. Figur 17).

Die auf den Träger 140 aufgebrachten Halbleiterchips 101, 102 und die hierauf angeordneten Konversionselemente 110, 120 sind derart aufeinander abgestimmt, dass die zusätzliche Kante 115 des ersten Konversionselements 110, wie in Figur 1 anhand einer gestrichelten Linie angedeutet ist, bezogen auf den Träger 140 auf gleicher bzw. im Wesentlichen gleicher Höhe liegen kann wie die vorderseitige Kante 125 des zweiten Konversionselements 120. Gegebenenfalls kann toleranzbedingt eine geringe Höhenversetzung, beispielsweise im Bereich von wenigen Mikrometern (zum Beispiel zehn Mikrometern) vorliegen.

Die übereinstimmende Kantenhöhe wird in einem nachfolgenden Verfahrensschritt 303 (vgl. Figur 5) ausgenutzt, in welchem wie in Figur 2 gezeigt ein weißes Isolationsmaterial 150 auf den Träger 140 aufgebracht wird, welches die Halbleiterchips 101, 102 und zum Teil die Konversionselemente 110, 120 umschließt. Das Isolationsmaterial 150 wird dazu verwendet, Bereiche zwischen den Halbleiterchips 101, 102 und um die Halbleiterchips 101, 102 herum zu verfüllen, wodurch in diesen Bereichen gegebenenfalls befindliche metallische Strukturen bzw. Flächen des Trägers 140 abgedeckt werden können. Auf diese Weise kann vermieden werden, dass ein in Richtung des Trägers 140 reflektierter Lichtanteil, beispielsweise hervorgerufen durch eine Reflexion an einer Linse des Bauelements 201, an den metallischen Flächen absorbiert wird. Dieser Lichtanteil kann an dem weißen Isolationsmaterial 150 rückreflektiert werden.

Das weiße Isolationsmaterial 150, welches in flüssiger bzw. zähflüssiger Form auf den Träger 140 aufgebracht und nachfolgend bei einer Temperatur von zum Beispiel 150°C ausgehärtet bzw. getrocknet wird, kann insbesondere weißes Silikon sein. Hierbei handelt es sich um Silikon, welches mit geeigneten Partikeln aus zum Beispiel Titanoxid oder Aluminiumoxid gefüllt ist.

Das Vergießen des Trägers 140 mit dem (zäh-)flüssigen Isolationsmaterial 150 wird derart durchgeführt, dass das Isolationsmaterial 150, wie in Figur 2 gezeigt, zu einem Niveau oberhalb der Halbleiterchips 101, 102 (bzw. deren Vorderseiten) verfüllt wird, und infolgedessen die Vorderseitenkontakte 105 von dem Isolationsmaterial 150 überdeckt werden. Dies ist im Hinblick auf die in einem späteren Verfahrensstadium hergestellte elektrische Kontaktierung der Halbleiterchips 101, 102 gewählt, welche auf und zum Teil in eingebetteter Form in dem Isolationsmaterial 150 ausgebildet wird.

Aufgrund der Stufenform des ersten Konversionselements 110 kann das Verfüllen mit dem Isolationsmaterial 150 derart durchgeführt werden, dass das Isolationsmaterial 150 im Bereich beider Halbleiterchips 101, 102 die gleiche bzw. im Wesentlichen gleiche Dicke aufweist. Durch die auf dem gleichen bzw. im Wesentlichen gleichen Niveau liegenden Kanten 115, 125 des ersten und zweiten Konversionselements 110, 120 ist es möglich, dass das Isolationsmaterial 150 zu beiden Kanten 115, 125 hin ansteigt, und an den Kanten 115, 125 aufgrund der Oberflächenspannung des Isolationsmaterials 150 gestoppt wird. Auf diese Weise kann verhindert werden, dass das Isolationsmaterial 150 beim Vergießen des Trägers 140 über das zweite Konversionselement 120 fließt und dessen Vorderseite überdeckt. Das verfüllte Isolationsmaterial 150, welches die Halbleiterchips 101, 102 und die Konversionselemente 110, 120 umfangsseitig umgibt, kann wie in Figur 2 angedeutet eine gewölbte Oberfläche, auch als Meniskus bezeichnet, aufweisen. Das mit der Stufenform erzielbare "symmetrische" Vergießen tritt in gleicher Weise bei einer Herstellung des Bauelements 201 mit einer Mehrzahl an lichtemittierenden Einheiten 101, 110 und 102, 120 auf.

Eine Verwendung unterschiedlicher Konversionselemente ohne Vorsehen einer solchen Stufenform, wobei Vorderseiten und damit Vorderkanten von Konversionselementen auf unterschiedlichem Niveau liegen, kann demgegenüber ein Überdecken einer tiefer liegenden Vorderseite zur Folge haben. Hierbei kann ein Ansteigen eines verwendeten Isolationsmaterials bis zu einer höher liegenden Vorderseite (bzw. Vorderkante) ein Ausbilden einer asymmetrischen Oberflächenwölbung in dem Isolationsmaterial zwischen den betreffenden Chips, und dadurch ein Überlaufen der niedrigeren Vorderseite mit dem Isolationsmaterial, zur Folge haben. Hierdurch kann die Vorderseite teilweise oder vollständig mit dem Isolationsmaterial bedeckt werden. Dies hat eine reduzierte Lichtemission des betreffenden Bauelements zur Folge.

Um ein zuverlässiges Stoppen des Isolationsmaterials 150 an der zusätzlichen Stoppkante 115 des ersten Konversionselements 110 bewirken zu können, weist der seitliche Überstand des ersten Abschnitts 111 gegenüber dem zweiten Abschnitt 112 im Querschnitt eine geeignete laterale Tiefe 311 auf (vgl. Figur 1). Die Tiefe 311 kann zum Beispiel im Bereich von zehn Mikrometern oder mehr liegen.

Neben der Abdeckfunktion wird das weiße Isolationsmaterial 150 ferner zum Tragen bzw. Einbetten von Strukturen 160 zum elektrischen Kontaktieren der Halbleiterchips 101, 102 verwendet. Die Herstellung derartiger Strukturen 160, was bei dem gezeigten Bauelement 201 anhand einer einzelnen, die Vorderseitenkontakte 105 der zwei gezeigten Halbleiterchips 101, 102 verbindenden Kontaktstruktur 160 veranschaulicht wird, erfolgt im Rahmen eines weiteren Schritts 304 (vgl. Figur 5). Hierbei kann es sich um eine sogenannte CPHF-Metallisierung (Compact Planar High Flux) handeln.

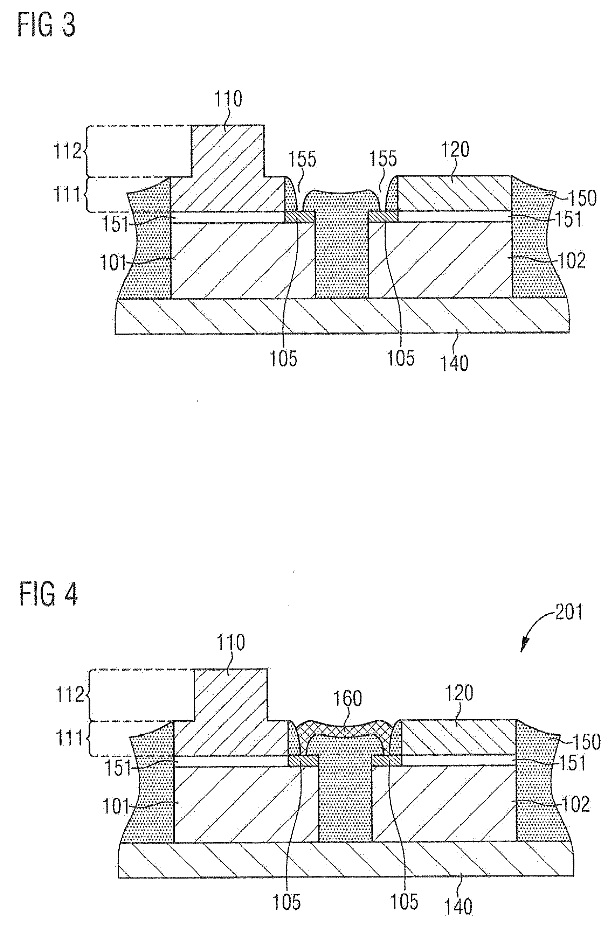

Bei dem Schritt 304 werden zunächst, wie in Figur 3 gezeigt, an die Vorderseitenkontakte 105 der Chips 101, 102 heranreichende bzw. die Vorderseitenkontakte 105 zum Teil freilegende Aussparungen 155 in dem ausgehärteten Isolationsmaterial 150 ausgebildet. Zu diesem Zweck kann zum Beispiel ein Laser zur Anwendung kommen, wodurch das Isolationsmaterial 150 relativ genau entfernt werden kann. Hieran anschließend wird ein metallisches Material unter Auffüllen der Aussparungen 155 auf das Isolationsmaterial 150 und die freiliegenden Stellen der Vorderseitenkontakte 105 aufgebracht, so dass wie in Figur 4 gezeigt eine die Vorderseitenkontakte 105 verbindende Kontaktstruktur 160 ausgebildet wird.

Das Metallisieren kann zum Beispiel das Durchführen eines Galvanikverfahrens umfassen. Hierbei kann vorgesehen sein, eine Keimschicht großflächig auf das Isolationsmaterial 150, die freiliegenden Teilbereiche der Vorderseitenkontakte 105 und die Konversionselemente 110, 120 aufzubringen, die Keimschicht zum Festlegen der (lateralen) Form der herzustellenden Kontaktstruktur 160 beispielsweise mittels eines Fotolacks zu maskieren, und nachfolgend ein Metall elektrochemisch abzuscheiden. Die Abscheidung findet dabei lediglich an nicht maskierten Stellen auf der Keimschicht statt. Anschließend kann die Maskierung entfernt und die Keimschicht außerhalb der betreffenden Kontaktstruktur 160 durch Ätzen abgetragen werden. Als Material für die Keimschicht und das abgeschiedene Metall kann zum Beispiel Kupfer in Betracht kommen.

Bei einer Mehrzahl von Halbleiterchips 101, 102 können im Rahmen des Schritts 304 entsprechend des vorstehend beschriebenen Ansatzes in gemeinsamer Weise mehrere Kontaktstrukturen 160 zum Kontaktieren von Vorderseitenkontakten 105 von Halbleiterchips 101, 102 erzeugt werden. Hierbei kann die laterale Form derartiger Kontaktstrukturen 160 abhängig von der jeweiligen Orientierung der Halbleiterchips 101, 102 sein. Bei dem Bauelement 201 von Figur 4 mit den einander zugewandten und die Vorderseitenkontakte 105 aufweisenden Chipbereichen kann die gezeigte Kontaktstruktur 160 zum Beispiel eine in der Aufsicht gerade Linienform besitzen. Hiervon abweichend sind andere Formen, wie zum Beispiel eine in der Aufsicht (teilweise) um einen Chip herum verlaufende Struktur, möglich.

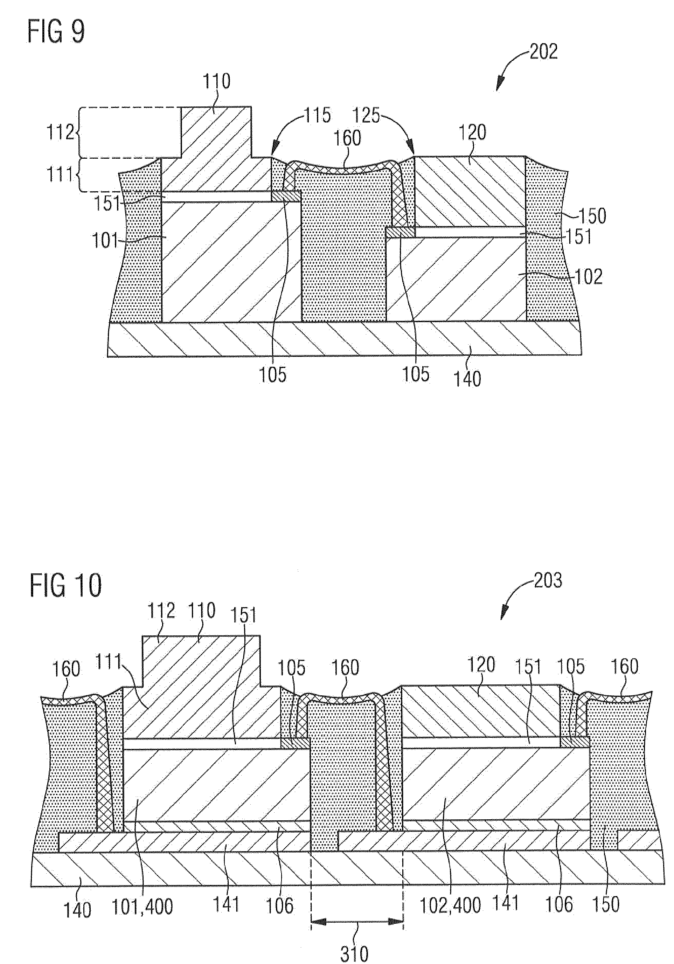

Darüber hinaus können mit einer Kontaktstruktur 160 auch Vorderseitenkontakte von zwei ersten Halbleiterchips 101 oder von zwei zweiten Halbleiterchips 102 elektrisch verbunden werden. Des Weiteren ist es möglich, eine Kontaktstruktur 160 auszubilden, über welche ein Vorderseitenkontakt 105 eines Halbleiterchips 101, 102 an einen Kontakt des Trägers 140 angeschlossen ist (vgl. Figur 10). Hierbei wird vor dem Metallisieren eine an den Kontakt des Trägers 140 heranreichende Aussparung in dem Isolationsmaterial 150 ausgebildet.

Nach dem Ausbilden der Kontaktstrukturen 160 können weitere, nicht dargestellte Prozesse zum Vervollständigen des optoelektronischen Bauelements 201 von Figur 4 durchgeführt werden. Derartige Schritte sind in dem Ablaufdiagramm von Figur 5 in einem weiteren Schritt 305 zusammengefasst. Hierunter fällt zum Beispiel ein (weiteres) Vergießen des Bauelements 201, ein Anordnen einer Linse, ein Anordnen bzw. Ausbilden eines Mischelements zum Mischen der unterschiedlichen Lichtstrahlungen (mint und rot), usw.

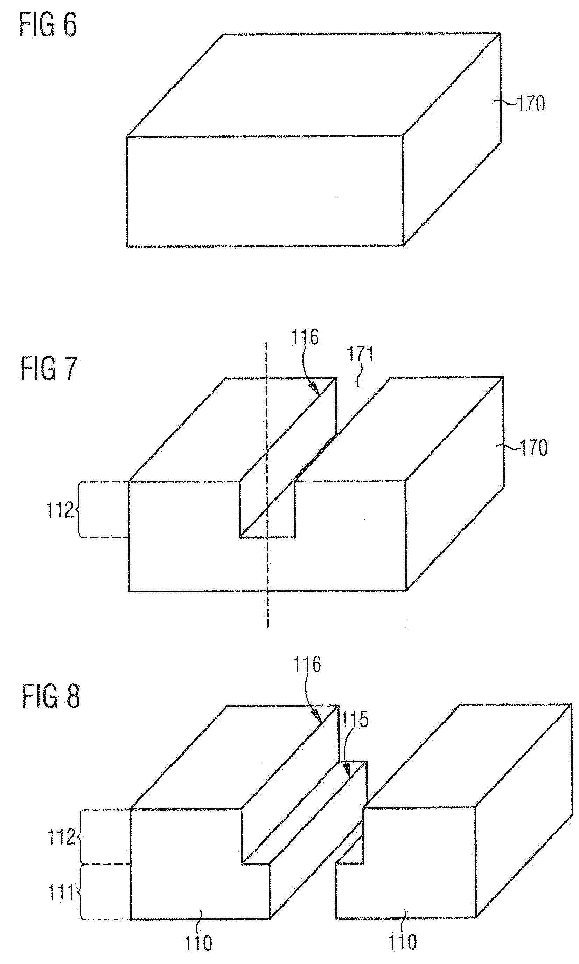

Das im Rahmen des Schritts 301 durchgeführte Bereitstellen eines stufenförmigen Konversionselements 110 kann auf der Grundlage eines zweistufigen Strukturierungsverfahrens erfolgen. Dies wird im Folgenden anhand der Figuren 6 bis 8 näher beschrieben, welche eine Herstellung ausschnittsweise in perspektivischer Form veranschaulichen. Hierbei wird zunächst, wie in Figur 6 gezeigt ist, ein plattenförmiges Ausgangselement 170 bereitgestellt. Das Ausgangselement 170 ist aus dem gleichen Material ausgebildet wie ein herzustellendes Konversionselement 110 (keramisch oder partikelgefülltes Silikon). Aus dem Ausgangselement 170 können insbesondere mehrere Konversionselemente 110 erzeugt werden.

Wie in Figur 7 ausschnittsweise angedeutet ist, wird in einem ersten Strukturierungsschritt eine Vertiefungsstruktur 171 in dem Ausgangselement 170 ausgebildet. Die Vertiefungsstruktur 171 dient dazu, die Kontur des zweiten Abschnitts 112 (und damit auch der Vorderkante 116) eines Konversionselements 110 vorzugeben, und weist zu diesem Zweck eine auf den zweiten Abschnitt 112 abgestimmte bzw. eine einen zweiten Abschnitt 112 umlaufende Form auf (nicht dargestellt). Für das Herstellen mehrerer Konversionselemente 110 aus dem Ausgangselement 170 liegt die Vertiefungsstruktur 171 als zusammenhängende Struktur vor, welche mehrere zweite Abschnitte 112 umläuft und daher, wie in Figur 7 anhand der gestrichelten Linie angedeutet ist, voneinander trennt.

Das Ausbilden der Vertiefungsstruktur 171 kann, bei Vorliegen eines keramischen Ausgangselements 170, zum Beispiel durch einen Sägeprozess erfolgen. Hierbei kann das Ausgangselement 170 mit einem relativ dicken Sägeblatt angeritzt werden. Bei einem Ausgangselement 170 aus partikelgefülltem Silikon kann stattdessen ein Laser zur Anwendung kommen.

Im Anschluss hieran wird ein zweiter Strukturierungsschritt durchgeführt, in welchem wie in Figur 8 ausschnittsweise angedeutet ist, ein finales Durchtrennen des Ausgangselements 170, und dadurch Erzeugen mehrerer vereinzelter Konversionselemente 110, stattfinden kann. Bei diesem Schritt wird ferner die Kontur des ersten Abschnitts 111 (und damit auch der umlaufenden Stoppkante 115) eines bzw. der Konversionselemente 110 festgelegt. Bei einem keramischen Ausgangselement 170 kann erneut ein Sägeprozess, hier mit einem relativ dünnen Sägeblatt, durchgeführt werden. Bei einem Ausgangselement 170 aus partikelgefülltem Silikon kann das Durchtrennen mit Hilfe eines Lasers erfolgen.

Anhand der folgenden Figuren werden Ausführungsformen weiterer optoelektronischer Bauelemente beschrieben. Diese sind basierend auf den vorstehend beschriebenen Ansätzen ausgebildet, und weisen in gleicher Weise stufenförmige Konversionselemente 110 und Konversionselemente 120 ohne Stufenform auf. Es wird darauf hingewiesen, dass in Bezug auf bereits beschriebene Details, welche sich auf gleichartige oder übereinstimmende Komponenten und Merkmale, mögliche Vorteile, mögliche Schritte zur Herstellung usw. beziehen, auf die vorstehenden Ausführungen Bezug genommen wird. Des Weiteren ist es möglich, dass Merkmale und Aspekte, welche im Hinblick auf eine der folgenden Ausführungsformen genannt werden, auch bei anderen der im Folgenden beschriebenen Ausführungsformen, oder auch bei dem Bauelement 201 von Figur 4, zur Anwendung kommen können.

Die vorteilhafte Wirkung von stufenförmigen Konversionselementen 110 kann nicht nur bei Vorliegen von unterschiedlich dicken Konversionselementen 110, 120 ausgenutzt werden. Zur Veranschaulichung zeigt Figur 9 einen Ausschnitt eines weiteren optoelektronischen Bauelements 202, bei dem nicht nur die Konversionselemente 110, 120, sondern zusätzlich auch die verwendeten optoelektronischen Halbleiterchips 101, 102 unterschiedliche Dicken aufweisen. Dies kann von einem unterschiedlichen Aufbau der verwendeten Halbleiterchips 101, 102 herrühren. Die Form des ersten Konversionselements 110 ist hierauf abgestimmt, so dass sich die zusätzliche Kante 115 erneut auf dem gleichen bzw. im Wesentlichen gleichen Niveau befindet wie die Vorderkante 125 des zweiten Konversionselements 120. Dadurch kann beim Verfüllen des Isolationsmaterials 150 ein Überdecken der Vorderseite des zweiten Konversionselements 120 vermieden werden.

Dieser Vorteil kann in analoger Weise bei einer solchen Ausführungsform erzielt werden, bei welcher lediglich die einzelnen Halbleiterchips 101, 102 unterschiedliche Dicken aufweisen, wohingegen die dazugehörigen Konversionselemente 110, 120, erneut ausgebildet mit und ohne Stufenform, übereinstimmende Dicken besitzen (nicht dargestellt).

Ein optoelektronisches Bauelement kann derart aufgebaut werden, dass mehrere oder sämtliche Halbleiterchips 101, 102 in Form einer Reihenverbindung elektrisch miteinander verbunden sind. Mögliche Ausführungsformen hierzu werden im Folgenden näher beschrieben.

Figur 10 zeigt einen Ausschnitt eines weiteren optoelektronischen Bauelements 203 mit in Reihe verbundenen optoelektronischen Halbleiterchips 101, 102 und hierauf angeordneten Konversionselementen 110, 120 mit und ohne Stufenform. Die Halbleiterchips 101, 102 weisen jeweils einen metallischen Vorderseitenkontakt 105 und jeweils einen metallischen Rückseitenkontakt 106 auf. Des Weiteren können die (zumindest zwei gezeigten) Halbleiterchips 101, 102 mit den die Kontakte 105 aufweisenden Chipbereichen in die gleiche Richtung orientiert sein. Der dazugehörige Träger 140 des Bauelements 203 ist mit Gegenkontakten in Form von metallischen Kontaktflächen 141 für die Rückseitenkontakte 106 ausgebildet. Bei den hierauf angeordneten Halbleiterchips 101, 102 kann eine Verbindung zwischen den Rückseitenkontakten 106 und den Kontaktflächen 141 zum Beispiel über ein Lotmittel hergestellt sein.

Wie des Weiteren in Figur 10 dargestellt ist, umfasst das Bauelement 203 ferner eine auf dem Isolationsmaterial 150 angeordnete und zum Teil in das Isolationsmaterial 150 eingebettete Kontaktstruktur 160, welche den Vorderseitenkontakt 105 des gezeigten ersten Halbleiterchips 101 mit derjenigen Kontaktfläche 141 des Trägers 140 verbindet, auf welcher der gezeigte zweite Halbleiterchip 102 angeordnet ist. Eine vergleichbare elektrische Verbindung kann zu weiteren, nicht dargestellten Halbleiterchips 101, 102 ausgebildet sein, wie in Figur 10 anhand von weiteren, teilweise gezeigten Kontaktstrukturen 160 angedeutet ist.

Für die elektrische Verbindung sind die Kontaktflächen 141 des Trägers 140 mit größeren lateralen Abmessungen als die Halbleiterchips 101, 102 ausgebildet. Hierdurch können die Halbleiterchips 101, 102, wie in Figur 10 gezeigt, derart auf den Kontaktflächen 141 positioniert werden, dass ein seitlich gegenüber den Halbleiterchips 101, 102 hervorstehender Teilbereich der Kontaktflächen 141 zum Anschließen der Kontaktstrukturen 160 zur Verfügung steht. Bei dem Ausbilden der Kontaktstrukturen 160 werden vor dem Metallisieren an diese Teilbereiche der Kontaktflächen 141 heranreichende Aussparungen in dem Isolationsmaterial 150 ausgebildet.

In Figur 10 ist des Weiteren ein zwischen den Halbleiterchips 101, 102 vorliegender Abstand 310 angedeutet. Das vorgesehene Kontaktieren der Kontaktflächen 141 des Trägers 140 über die Kontaktstrukturen 160 kann einen etwas größeren Chipabstand 310, beispielsweise von 250 Mikrometern oder mehr, zur Folge haben.

Die in Figur 10 gezeigte elektrische Reihenverbindung kann nicht nur abwechselnd jeweils zwischen einem ersten und zweiten Halbleiterchip 101, 102 vorliegen. Möglich ist es auch, mehrere erste Halbleiterchips 101 mit stufenförmigen Konversionselementen 110 sowie mehrere zweite Halbleiterchips 102 mit Konversionselementen 120 ohne Stufenform in der veranschaulichten Weise zu verbinden.

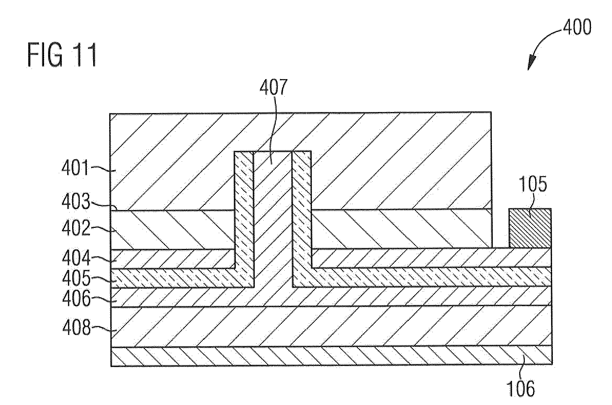

Figur 11 zeigt eine schematische seitliche Darstellung einer möglichen Ausführungsform eines Halbleiter- bzw. LED-Chips 400, welche insbesondere für die Halbleiterchips 101, 102 des in Figur 10 gezeigten Bauelements 203 in Betracht kommen kann. Der Halbleiterchip 400 von Figur 11 weist einen Halbleiterkörper mit einer Schichtenfolge umfassend eine erste Halbleiterschicht 401, eine zweite Halbleiterschicht 402 und eine dazwischen vorliegende aktive Zone 403 zur Strahlungserzeugung auf. Die beiden Halbleiterschichten 401, 402 weisen unterschiedliche Leitfähigkeiten bzw. Dotierungen auf. Der Halbleiterkörper ist auf einer leitfähigen Stromaufweitungsschicht 404 angeordnet, auf welcher seitlich von dem Halbleiterkörper ein metallischer Vorderseitenkontakt 105 angeordnet ist. Die Stromaufweitungsschicht 404 ermöglicht einen gleichmäßigen Stromfluss. Ein (nicht dargestelltes) Konversionselement kann vorderseitig auf den Halbleiterkörper bzw. auf die Halbleiterschicht 401 aufgeklebt sein.

Der Halbleiterchip 400 weist des Weiteren einen Durchgangskontakt 407 auf. Für den Durchgangskontakt 407 ist eine sich vertikal durch die Stromaufweitungsschicht 404, die Halbleiterschicht 402, die aktive Zone 403, und in die Halbleiterschicht 401 hinein erstreckende Ausnehmung ausgebildet, welche am Rand mit einer Isolationsschicht 405, und mit einer von der Isolationsschicht 405 umgebenen leitfähigen Schicht 406 verfüllt ist. Die leitfähige Schicht 406 kontaktiert die Halbleiterschicht 401. Außerhalb des Durchgangskontakts 407 sind die Stromaufweitungsschicht 404, die Isolationsschicht 405 und die leitfähige Schicht 406 in Form eines Schichtenstapels übereinander angeordnet. Die leitfähige Schicht 406 ist ferner auf einem leitfähigen Trägersubstrat 408 angeordnet, auf welchem rückseitig ein metallischer Rückseitenkontakt 106 angeordnet ist. Eine Verbindung zwischen der leitfähigen Schicht 406 und dem Trägersubstrat 408 kann über eine nicht dargestellte Verbindungsschicht hergestellt sein. Der Halbleiterchip 400 kann mit mehreren solchen Durchgangskontakten 407 ausgebildet sein.

Bei dem Halbleiterchip 400 ist der Vorderseitenkontakt 105 über die Stromaufweitungsschicht 404 elektrisch mit der zweiten Halbleiterschicht 402 verbunden. Der Rückseitenkontakt 106 ist über das Trägersubstrat 408, die leitfähige Schicht 406 und den/die Durchgangskontakt(e) 407 elektrisch mit der ersten Halbleiterschicht 401 verbunden. Beispielsweise kann die zweite Halbleiterschicht 402 p-leitend sein, so dass der Vorderseitenkontakt 105 einen p-Kontakt darstellt. Die andere Halbleiterschicht 401 kann demgegenüber n-leitend sein, so dass der Rückseitenkontakt 106 einen n-Kontakt darstellt. In Bezug auf das Bauelement 203 von Figur 10 kann in dieser Hinsicht ein p-Kontakt 105 über eine Kontaktstruktur 160 und eine Kontaktfläche 141 an einen n-Kontakt 106 angeschlossen sein.

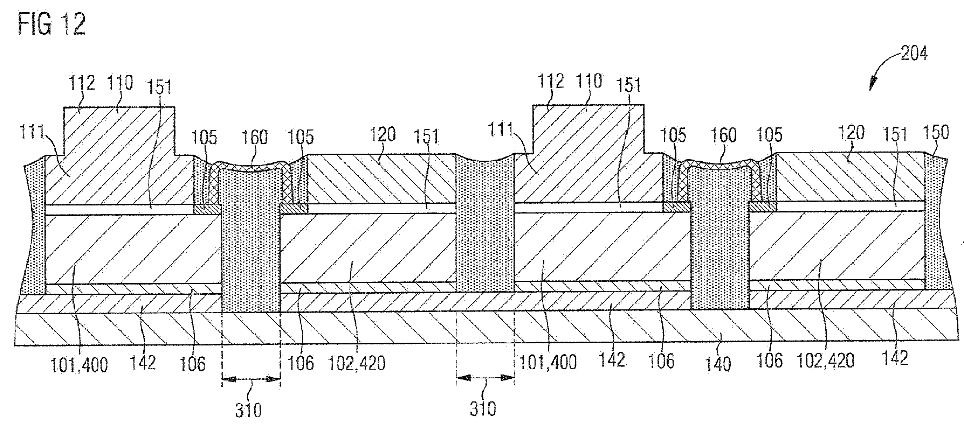

Figur 12 zeigt einen Ausschnitt eines weiteren optoelektronischen Bauelements 204 mit in Reihe verbundenen optoelektronischen Halbleiterchips 101, 102 und hierauf angeordneten Konversionselementen 110, 120. Die Halbleiterchips 101, 102 weisen jeweils einen metallischen Vorderseitenkontakt 105 und jeweils einen metallischen Rückseitenkontakt 106 auf. Bei dem Bauelement 204 sind in abwechselnder Weise jeweils Vorderseitenkontakte 105 und jeweils Rückseitenkontakte 106 von ersten und zweiten Halbleiterchips 101, 102 elektrisch verbunden. Zu diesem Zweck ist der Träger 140 mit relativ großen metallischen Kontaktflächen 142 ausgebildet. Auf den Kontaktflächen 142 ist jeweils ein erster und zweiter Halbleiterchip 101, 102 angeordnet. Eine Verbindung zwischen den Rückseitenkontakten 106 und den Kontaktflächen 142 kann erneut beispielsweise über ein Lotmittel hergestellt sein.

Bei den auf einer gemeinsamen Kontaktfläche 142 angeordneten Halbleiterchips 101, 102 sind die Rückseitenkontakte 106 elektrisch über die Kontaktfläche 142 verbunden. Elektrische Verbindungen zu anderen, gemeinsam auf einer Kontaktfläche 142 positionierten Halbleiterchips 101, 102, sind über Kontaktstrukturen 160 hergestellt. Dabei sind jeweils Vorderseitenkontakte 105 eines ersten und zweiten Halbleiterchips 101, 102 elektrisch verbunden. Zumindest die in Figur 12 gezeigten Halbleiterchips 101, 102 können hierbei mit den die Kontakte 105 aufweisenden Chipbereichen einander zugewandt sein. Die Kontaktstrukturen 160 sind auf dem Isolationsmaterial 150 angeordnet und zum Teil in das Isolationsmaterial 150 eingebettet, und erstrecken sich daher zu den betreffenden Vorderseitenkontakten 105. Die veranschaulichte elektrische Verbindung kann zu weiteren, nicht dargestellten Halbleiterchips 101, 102 hin fortgesetzt sein.

In Figur 12 sind ferner zwischen den Halbleiterchips 101, 102 vorliegende Abstände 310 angedeutet. Die Abstände 310 können relativ klein sein, und zum Beispiel fünfzig Mikrometer betragen. Die in Figur 12 gezeigte elektrische Reihenverbindung kann nicht nur abwechselnd jeweils zwischen einem ersten und zweiten Halbleiterchip 101, 102 vorliegen. Möglich ist auch eine Abwandlung derart, dass mehrere erste Halbleiterchips 101 mit stufenförmigen Konversionselementen 110 sowie mehrere zweite Halbleiterchips 102 mit Konversionselementen 120 in der veranschaulichten Weise verbunden sind.

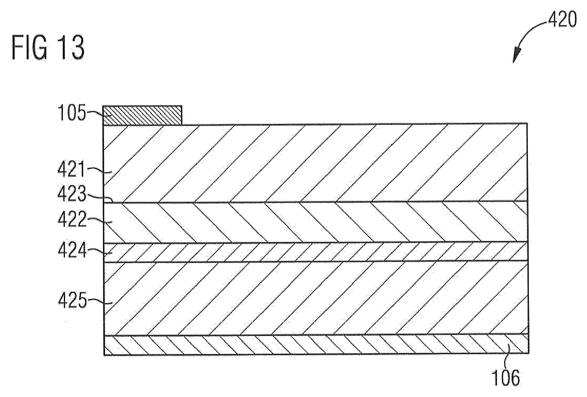

Bei dem Bauelement 204 von Figur 12 kann zum Beispiel der Vorderseitenkontakt 105 eines Halbleiterchips 101 einen p-Kontakt, und der hiermit elektrisch verbundene Vorderseitenkontakt 105 eines Halbleiterchips 102 einen n-Kontakt darstellen. Demgegenüber kann der Rückseitenkontakt 106 eines Halbleiterchips 101 einen n-Kontakt, und der hiermit verbundene Rückseitenkontakt 106 eines Halbleiterchips 102 einen p-Kontakt darstellen. Zu diesem Zweck kann zum Beispiel für einen Halbleiterchip 101 die anhand von Figur 11 erläuterte Ausführungsform eines Halbleiterchips 400 zur Anwendung kommen. Für einen Halbleiterchip 102 kann die im Folgenden anhand von Figur 13 beschriebene Ausführungsform eingesetzt werden.

Figur 13 zeigt eine schematische seitliche Darstellung eines weiteren Halbleiter- bzw. LED-Chips 420. Der Halbleiterchip 420 weist eine Schichtenfolge umfassend eine erste Halbleiterschicht 421, eine zweite Halbleiterschicht 422 und eine dazwischen vorliegende aktive Zone 423 zur Strahlungserzeugung auf. Die beiden Halbleiterschichten 421, 422 weisen unterschiedliche Leitfähigkeiten auf. Vorderseitig ist am Rand auf der Schichtenfolge bzw. auf der Halbleiterschicht 421 ein metallischer Vorderseitenkontakt 105 angeordnet. Die Schichtenfolge ist ferner über eine Zwischenschicht 424 mit einem leitfähigen Trägersubstrat 425 verbunden, auf welchem rückseitig ein metallischer Rückseitenkontakt 106 angeordnet ist. Ein (nicht dargestelltes) Konversionselement kann vorderseitig auf die Halbleiterschicht 421 aufgeklebt sein.

Bei dem Halbleiterchip 420 kontaktiert der Vorderseitenkontakt 105 die erste Halbleiterschicht 421. Der Rückseitenkontakt 106 ist über das Trägersubstrat 425 und die Zwischenschicht 424 elektrisch mit der zweiten Halbleiterschicht 422 verbunden. Beispielsweise können die erste Halbleiterschicht 421 n-leitend und die zweite Halbleiterschicht 422 p-leitend sein, so dass der Vorderseitenkontakt 105, wie oben mit Bezug auf das Bauelement 204 von Figur 12 angegeben, einen n-Kontakt, und der Rückseitenkontakt 106 einen p-Kontakt darstellt.

Der in Figur 13 gezeigte Chipaufbau kann in gleicher Weise für die entsprechend Figur 10 in Reihe verbundenen Halbleiterchips 101, 102 (d.h. für sämtliche Chips 101, 102) vorgesehen sein.

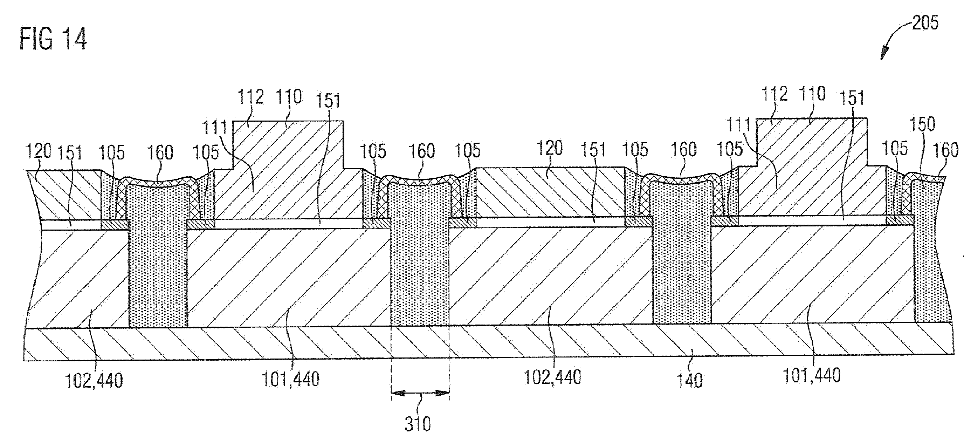

Figur 14 zeigt einen Ausschnitt eines weiteren optoelektronischen Bauelements 205 mit in Reihe verbundenen optoelektronischen Halbleiterchips 101, 102 und hierauf angeordneten Konversionselementen 110, 120. Die Halbleiterchips 101, 102 weisen jeweils zwei, an entgegen gesetzten Randseiten angeordnete metallische Vorderseitenkontakte 105, und daher keinen Rückseitenkontakt auf. Die Vorderseitenkontakte 105 der nebeneinander angeordneten Halbleiterchips 101, 102 sind über Kontaktstrukturen 160 elektrisch verbunden. Hierbei können zumindest die in Figur 14 gezeigten Halbleiterchips 101, 102 mit den die Vorderseitenkontakte 105 aufweisenden Chipbereichen einander zugewandt sein. Die Kontaktstrukturen 160 sind auf dem Isolationsmaterial 150 angeordnet und zum Teil in das Isolationsmaterial 150 eingebettet, und erstrecken sich daher zu den betreffenden Vorderseitenkontakten 105. Die gezeigte elektrische Verbindung kann zu weiteren, nicht dargestellten Halbleiterchips 101, 102 hin fortgesetzt sein.

Bei dem Bauelement 205 sind die Halbleiterchips 101, 102 lediglich mechanisch mit dem Träger 140 verbunden. In dieser Ausgestaltung kann die mechanische Verbindung zum Beispiel ebenfalls unter Verwendung eines Lotmittels hergestellt sein. Hierbei können die Halbleiterchips 101, 102 und der Träger 140 aufeinander abgestimmte metallische Schichten aufweisen, welche über das Lotmittel verbunden werden (nicht dargestellt). Bei den Halbleiterchips 101, 102 können diese Schichten auf der Rückseite vorgesehen sein. Des Weiteren kann der Träger 140 im Wesentlichen in Form einer Wärmesenke ausgebildet sein.

Die Halbleiterchips 101, 102 des Bauelements 205 können mit relativ kleinen Abständen 310 zueinander auf dem Träger 140 positioniert sein. Die Abstände 310 können zum Beispiel fünfzig Mikrometer betragen. Des Weiteren kann die in Figur 14 gezeigte elektrische Reihenverbindung nicht nur abwechselnd jeweils zwischen einem ersten und zweiten Halbleiterchip 101, 102 vorliegen. Möglich ist es auch, mehrere erste Halbleiterchips 101 mit stufenförmigen Konversionselementen 110 sowie mehrere zweite Halbleiterchips 102 mit Konversionselementen 120 in der veranschaulichten Weise zu verbinden.

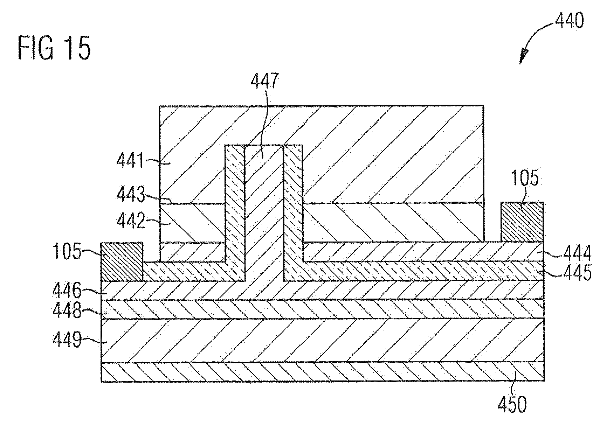

Bei den Halbleiterchips 101, 102 des Bauelements 205 stellt jeweils ein Kontakt 105 einen p-Kontakt und der andere Kontakt 105 einen n-Kontakt dar. Für eine solche Ausgestaltung können die Halbleiterchips 101, 102 entsprechend der im Folgenden anhand von Figur 15 beschriebener Ausführungsform ausgebildet sein.

Figur 15 zeigt eine schematische seitliche Darstellung eines weiteren Halbleiter- bzw. LED-Chips 440. Der Halbleiterchip 440 weist einen Halbleiterkörper mit einer Schichtenfolge umfassend eine erste Halbleiterschicht 441, eine zweite Halbleiterschicht 442 und eine dazwischen vorliegende aktive Zone 443 zur Strahlungserzeugung auf. Die beiden Halbleiterschichten 441, 442 weisen unterschiedliche Leitfähigkeiten bzw. Dotierungen auf. Der Halbleiterkörper ist auf einer leitfähigen Stromaufweitungsschicht 444 angeordnet, auf welcher seitlich von dem Halbleiterkörper ein metallischer Vorderseitenkontakt 105 angeordnet ist (rechts in Figur 15). Ein (nicht dargestelltes) Konversionselement kann vorderseitig auf den Halbleiterkörper bzw. auf die Halbleiterschicht 441 aufgeklebt sein.

Der Halbleiterchip 440 weist des Weiteren einen Durchgangskontakt 447 auf. Für den Durchgangskontakt 447 ist eine sich vertikal durch die Stromaufweitungsschicht 444, die Halbleiterschicht 442, die aktive Zone 443, und in die Halbleiterschicht 441 hinein erstreckende Ausnehmung ausgebildet, welche am Rand mit einer Isolationsschicht 445, und mit einer von der Isolationsschicht 445 umgebenen leitfähigen Schicht 446 verfüllt ist. Die leitfähige Schicht 446 kontaktiert die Halbleiterschicht 441. Außerhalb des Durchgangskontakts 447 liegen die Stromaufweitungsschicht 444, die Isolationsschicht 445 und die leitfähige Schicht 446 übereinander in Form eines Schichtenstapels vor. Ein weiterer metallischer Vorderseitenkontakt 105 ist am Rand auf einem Teilbereich der leitfähigen Schicht 446 angeordnet (links in Figur 15). Die leitfähige Schicht 446 ist ferner über eine Verbindungsschicht 448 mit einem isolierenden Trägersubstrat 449 verbunden. Auf dem Trägersubstrat 449 ist rückseitig eine metallische Schicht 450 angeordnet, welche wie oben beschrieben zum Verbinden mit einer metallischen Schicht eines Trägers 140 verwendet werden kann. Der Halbleiterchip 440 kann mit mehreren solchen Durchgangskontakten 447 ausgebildet sein.

Bei dem Halbleiterchip 440 ist der rechte Vorderseitenkontakt 105 über die Stromaufweitungsschicht 444 elektrisch mit der zweiten Halbleiterschicht 442 verbunden. Der andere, linke Vorderseitenkontakt 105 ist über die leitfähige Schicht 446 und den/die Durchgangskontakt(e) 447 elektrisch mit der ersten Halbleiterschicht 441 verbunden. Beispielsweise kann die zweite Halbleiterschicht 442 p-leitend sein, so dass der rechte Vorderseitenkontakt 105 einen p-Kontakt darstellt. Die erste Halbleiterschicht 441 kann demgegenüber n-leitend sein, so dass der andere Vorderseitenkontakt 105 einen n-Kontakt darstellt.

Wie oben angedeutet wurde, kann ein optoelektronisches Bauelement eine Mehrzahl an Halbleiterchips 101, 102 umfassen, wobei die Halbleiterchips 101, 102 in geeigneter Weise verteilt auf einem Träger 140 angeordnet sein können. Die Halbleiterchips 101, 102 können hierbei relativ nah zueinander positioniert sein, wodurch eine hohe Leuchtdichte, und im Hinblick auf das Mischen von Lichtstrahlungen unterschiedlicher Spektralbereiche, insbesondere wie oben beschrieben von mintfarbener und roter Lichtstrahlung zu einer weißen bzw. warmweißen Lichtstrahlung, eine hohe Homogenität der resultierenden Lichtstrahlung erzielt werden kann.

Zur Veranschaulichung zeigt Figur 16 eine schematische Aufsichtsdarstellung einer möglichen bzw. beispielhaften Anordnung von Halbleiterchips 101, 102 und hierauf angeordneten Konversionselementen 110, 120 mit und ohne Stufenform eines optoelektronischen Bauelements 206. Die Halbleiterchips 101, 102 weisen am Rand bzw. an einer Ecke jeweils einen einzelnen Vorderseitenkontakt 105 auf. Bei einer Ausgestaltung als Weißlichtquelle können zum Beispiel die lichtemittierenden Einheiten 101, 110 zum Erzeugen einer mintfarbenen, und die lichtemittierenden Einheiten 102, 120 zum Erzeugen einer roten Lichtstrahlung (oder umgekehrt) ausgebildet sein.

Bei dem Bauelement 206 kann eine nicht gezeigte elektrische Kontaktierung von Halbleiterchips 101, 102 basierend auf den oben beschriebenen Ansätzen, beispielsweise in einer Figur 10 entsprechenden Weise, verwirklicht sein. Dabei können zum Beispiel sämtliche Halbleiterchips 101, 102 in Reihe verbunden sein. Alternativ kann zum Beispiel in Betracht kommen, mehrere separate Reihenverbindungen von Halbleiterchips 101, 102 vorzusehen. In Bezug auf die elektrische Kontaktierung kann ferner vorgesehen sein, die einzelnen Halbleiterchips 101, 102 abweichend von Figur 16 auf andere Weise mit den Vorderseitenkontakten 105 zu orientieren.

Anhand der in Figur 16 gezeigten Chipanordnung wird ferner deutlich, dass die auf den Halbleiterchips 101, 102 angeordneten Konversionselemente 110, 120 - wie oben beschrieben - auf die Vorderseitenkontakte 105 der Halbleiterchips 101, 102 abgestimmte seitliche Aussparungen bzw. Einbuchtungen aufweisen. Hierdurch sind die Vorderseitenkontakte 105 für das Ausbilden von an die Vorderseitenkontakte 105 heranreichenden Kontaktstrukturen 160 frei zugänglich.

In Bezug auf ein stufenförmiges Konversionselement 110 wird dessen mögliche Form anhand der in Figur 17 gezeigten, vergrößerten Aufsichtsdarstellung eines Halbleiterchips 101 deutlich. Das Konversionselement 110 weist den seitlich über den zweiten Abschnitt 112 hervorstehenden ersten Abschnitt 111 auf. Die Stufenform, und damit die beiden Kanten bzw. Kantenstrukturen 115, 116, liegen über den gesamten Umfang des Konversionselements 110 vor. Hierbei besitzen die Abschnitte 111, 112 und Kantenstrukturen 115, 116 in der Aufsicht vergleichbare Geometrien und Konturen, einschließlich der auf den Vorderseitenkontakt 105 abgestimmten Aussparung.

Für den Fall von Halbleiterchips 101, 102 mit zwei Vorderseitenkontakten 105 (vgl. Figur 14) können die eingesetzten Konversionselemente 110, 120 in entsprechender Weise zwei, auf die zwei Vorderseitenkontakte 105 abgestimmte Aussparungen am Rand ausweisen. Dabei kann, von oben betrachtet, ebenfalls eine im Wesentlichen rechteckige bzw. quadratische Grundform vorliegen (nicht dargestellt). Bei einem stufenförmigen Konversionselement 110 können in gleicher Weise die Abschnitte 111, 112 und Kantenstrukturen 115, 116 in der Aufsicht vergleichbare Geometrien und Konturen, einschließlich auf die Vorderseitenkontakte 105 abgestimmter Aussparungen, aufweisen (nicht dargestellt).

Ein optoelektronisches Bauelement kann ferner mit einem oder mehreren zusätzlichen optoelektronischen Halbleiterchips ohne hierauf angeordnete Konversionselemente verwirklicht werden, so dass die primäre Lichtstrahlung nicht konvertiert wird. In Bezug auf eine Weißlichtquelle können auf diese Weise mintfarbene, rote und blaue Lichtstrahlungen überlagert werden. Um ein Überdecken eines Halbleiterchips ohne Konversionselement zu verhindern, kommt auf einem solchen Halbleiterchip ein durchsichtiger Abstandhalter zum Einsatz. Bei dem Bauelement 206 von Figur 16 kann beispielsweise bei einem der Halbleiterchips, zum Beispiel bei dem genau in der Mitte vorliegenden Halbleiterchip 102, anstelle des Konversionselements 120 ein solcher Anstandshalter zur Anwendung kommen.

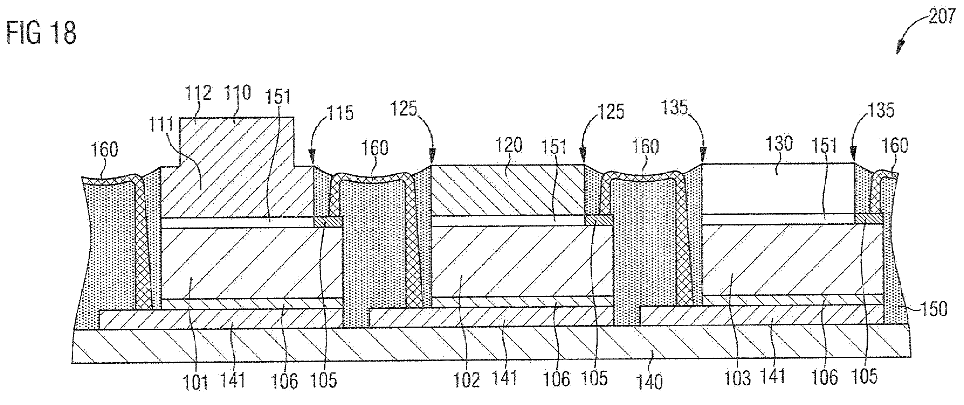

Zur beispielhaften Veranschaulichung zeigt Figur 18 einen Ausschnitt eines weiteren optoelektronischen Bauelements 207. Das Bauelement 207 weist Halbleiterchips 101, 102 mit hierauf angeordneten Konversionselementen 110, 120 mit und ohne Stufenform, und einen weiteren Halbleiterchip 103 mit einem hierauf angeordneten strahlungsdurchlässigen Element 130 auf. Die Halbleiterchips 101, 102, 103 weisen jeweils einen Vorderseitenkontakt 105 und einen Rückseitenkontakt 106 auf. Es ist möglich, dass die Halbleiterchips 101, 102, 103 den gleichen oder einen vergleichbaren Aufbau sowie, wie in Figur 18 angedeutet, die gleiche Höhe bzw. Dicke besitzen. Beispielsweise können sämtliche Halbleiterchips 101, 102, 103 einen Aufbau entsprechend Figur 11 oder 13 besitzen.

Das strahlungsdurchlässige Element 130 ist, vergleichbar zu den Konversionselementen 110, 120, über einen durchsichtigen Klebstoff 151 (Silikonkleber) vorderseitig mit dem Halbleiterchip 103 verbunden. Auch weist das Element 130 eine auf den Vorderseitenkontakt 105 des Halbleiterchips 103 abgestimmte Form mit einer am Rand bzw. an einer Ecke vorliegenden Aussparung auf. Das Element 130 kann in der Aufsicht die gleiche laterale Form besitzen wie ein zweites Konversionselement 120 (also beispielsweise wie in Figur 16 gezeigt). Ferner besitzt das Element 130, welches zum Beispiel aus durchsichtigem klarem Silikon ausgebildet sein kann, eine vorderseitig am Rand vorliegende umlaufende Kante bzw. Kantenstruktur 135.

Bei dem Bauelement 207 befinden sich nicht nur die Kanten 115, 125 der Konversionselemente, sondern auch die Kante 135 des strahlungsdurchlässigen Elements 130 auf der gleichen bzw. im Wesentlichen gleichen Höhe. Gegebenenfalls kann toleranzbedingt eine geringe Höhenversetzung von zum Beispiel wenigen Mikrometern, beispielsweise zehn Mikrometern, vorliegen. Die übereinstimmende Kantenhöhe ermöglicht erneut, dass bei einem Vergießen des Trägers 140 mit einem weißen Isolationsmaterial 150, wobei die Vorderseitenkontakte 105 der Halbleiterchips 101, 102, 103 von dem Isolationsmaterial 150 überdeckt werden, das Isolationsmaterial 105 an den Kanten 115, 125, 135 gestoppt wird, und daher das Isolationsmaterial 150 im Bereich sämtlicher Halbleiterchips 101, 102, 103 die gleiche bzw. im Wesentlichen gleiche Dicke aufweist. Auf diese Weise wird ein Überdecken sowohl des Konversionselements 120 als auch des Elements 130 vermieden.

Bei Verwendung gleich dicker Halbleiterchips 101, 102, 103, wie in Figur 18 gezeigt, weist das strahlungsdurchlässige Element 130 die gleiche Dicke wie das Konversionselement 120 auf. Alternativ ist jedoch auch eine Ausgestaltung des Bauelements 207 mit unterschiedlich aufgebauten Halbleiterchips 101, 102, 103, und dadurch gegebenenfalls unterschiedlichen Chipdicken, möglich. Beispielsweise können die Halbleiterchips 101, 102 baugleich sein, und kann der Halbleiterchip 103 einen hiervon abweichenden Aufbau und eine andere Dicke besitzen. Um auch bei solchen Ausgestaltungen weiterhin die beschriebene Stoppwirkung beim Vergießen des Trägers 140 hervorzurufen, können daher bei unterschiedlichen Chipdicken unterschiedliche Dicken des Elements 130 und des Konversionselements 120 in Betracht kommen.

Figur 18 veranschaulicht des Weiteren eine mögliche Kontaktierung der Halbleiterchips 101, 102, 103. Hierbei liegt eine Figur 10 entsprechende Struktur vor, d.h. dass die Halbleiterchips 101, 102, 103 mit den Rückseitenkontakten 106 auf Kontaktflächen 141 des Trägers 140 angeordnet sind, und Vorderseitenkontakte 105 über Kontaktstrukturen 160 an die Kontaktflächen 141 angeschlossen sind. Die veranschaulichte elektrische Verbindung kann zu weiteren, nicht dargestellten Halbleiterchips 101, 102, 103 hin fortgesetzt sein. Es ist ferner möglich, mehrere Halbleiterchips 103 mit hierauf angeordneten Elementen 130 elektrisch in Reihe zu verbinden.

Der anhand von Figur 18 beschriebene Einsatz von Halbleiterchips 103 mit strahlungsdurchlässigen Elementen 130 kann in analoger Weise mit anderen Kontaktierungsarten, beispielsweise den in Figur 12 und 14 gezeigten Ausgestaltungen, in Betracht kommen. In Bezug auf Figur 14 weist ein Halbleiterchip 103 hierbei zwei Vorderseitenkontakte 105 auf. In gleicher Weise kann ein strahlungsdurchlässiges Element 130 zwei, hierauf abgestimmte Aussparungen aufweisen.

Die anhand der Figuren erläuterten Ausführungsformen stellen bevorzugte bzw. beispielhafte Ausführungsformen der Erfindung dar. Neben den beschriebenen und abgebildeten Ausführungsformen sind weitere Ausführungsformen vorstellbar, welche weitere Abwandlungen bzw. Kombinationen von Merkmalen umfassen können. Beispielsweise können anstelle der oben angegebenen Materialien andere Materialien verwendet werden, und können obige Zahlenangaben zu Chipabständen, Dicken, usw. durch andere Angaben ersetzt werden.

Es ist es möglich, dass die gezeigten und beschriebenen optoelektronischen Halbleiterchips - insbesondere die in den Figuren 11, 13, 15 gezeigten Ausführungsbeispiele - andere oder zusätzliche Strukturen und Schichten (beispielsweise zusätzliche Spiegelschichten, usw.) umfassen, sowie dass anstelle der angegebenen Leitfähigkeiten hierzu inverte Leitfähigkeiten vorliegen. Ferner können optoelektronische Bauelemente auch mit anderen bzw. hiervon abweichenden Ausführungsformen von lichtemittierenden Halbleiter- bzw. Dünnfilmchips aufgebaut werden.

Anstelle der in den Figuren 16 und 17 gezeigten, zum Teil gekrümmten Form der Vorderseitenkontakte 105 können andere Formen, wie zum Beispiel eine rechteckige oder quadratische Form, in Betracht kommen. Dies ist auch bei Ausgestaltungen von Halbleiterchips mit zwei Kontakten 105 pro Chip möglich. Hierauf abgestimmt können Konversionselemente 110, 120 und strahlungsdurchlässige Elemente 130 andere Formen, insbesondere anders geformte Aussparungen, und dadurch in der Aufsicht andere Konturen von Kantenstrukturen 115, 116, 125, 135 aufweisen.

In Bezug auf eine Kontaktierung von Halbleiterchips ist die Möglichkeit gegeben, die anhand der Figuren 10, 12, 14 aufgezeigten Ansätze gegebenenfalls bei einem Bauelement zu kombinieren.

Des Weiteren ist es möglich, eine auf einem Isolationsmaterial 150 angeordnete Kontaktstruktur 160, welche einen Vorderseitenkontakt 105 eines am Ende einer Reihenverbindung angeordneten Halbleiterchips kontaktiert, in Form einer zum Kontaktieren des betreffenden Endes der Reihenverbindung dienenden Leiterbahnstruktur auszubilden.

Darüber hinaus wird auf die Möglichkeit hingewiesen, das Ausbilden von Kontaktstrukturen 160 nicht mit Hilfe eines Galvanikverfahrens, sondern basierend auf anderen Verfahren durchzuführen. Beispielsweise kann das Metallisieren das Aufbringen bzw. Verfüllen einer leitfähigen bzw. metallischen Paste oder eines Lotmittels umfassen.

Ein Bauelement kann basierend auf den obigen Ansätzen nicht nur in Form einer Weißlichtquelle, sondern auch in Form einer Lichtquelle zum Abgeben einer Lichtstrahlung mit einer anderen Farbe ausgebildet sein. Des Weiteren können die oben angegebenen Spektralbereiche für Primär- und Sekundärstrahlungen durch andere Spektralbereiche ersetzt werden. Beispielsweise kann in Betracht kommen, Halbleiterchips zum Erzeugen einer Primärstrahlung im ultravioletten Spektralbereich zu verwenden. Auch können Konversionselemente aus anderen als den oben angegebenen Materialien ausgebildet sein. Ein Beispiel eines Konversionsmaterials zum Erzeugen einer gelb-orangen Lichtstrahlung ist mit Europium dotiertes CaSiAlON.

Es kann darüber hinaus in Betracht kommen, ein Bauelement sowohl mit keramischen Konversionselementen als auch mit Konversionselementen aus partikelgefülltem Silikon aufzubauen. Auch wird auf die Möglichkeit hingewiesen, ein Bauelement mit mehr als zwei unterschiedlichen Typen von Konversionselementen, d.h. zum Erzeugen von mehr als zwei unterschiedlichen Sekundärstrahlungen bzw. Farben, auszubilden. Bei derartigen Ansätzen kann ebenfalls durch eine stufenförmige Ausgestaltung von Konversionselementen erzielt werden, dass ein Überdecken von (niedrigeren) Konversionselementen mit einem Isolationsmaterial bei einem Vergießen verhindert wird.

Möglich ist es ferner, zusätzlich oder alternativ zu einer Reihenschaltung von Halbleiterchips eine Parallelschaltung vorzusehen. Auch kann gegebenenfalls in Betracht kommen, an Halbleiterchips derartige Kontaktstrukturen anzuschließen, mit deren Hilfe ein getrenntes Ansteuern bzw. Bestromen einzelner oder mehrerer Halbleiterchips möglich ist. Anstelle eines weißen Silikons kann ein anderes reflektives bzw. weißes Vergussmaterial zur Anwendung kommen. Hierunter kann ein geeignetes Polymermaterial wie zum Beispiel ein Epoxidmaterial fallen, welches ebenfalls mit Streupartikeln gefüllt sein kann.

Obwohl die Erfindung im Detail durch bevorzugte bzw. beispielhafte Ausführungsformen näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Diese Patentanmeldung beansprucht die Priorität der deutschen Patentanmeldung 10 2012 217 521.

### Bezugszeichenliste

- 101, 102: Halbleiterchip
- 103: Halbleiterchip
- 105: Vorderseitenkontakt
- 106: Rückseitenkontakt
- 110: Konversionselement
- 111, 112: Abschnitt
- 115, 116: Kante
- 120: Konversionselement
- 125: Kante
- 130: strahlungsdurchlässiges Element
- 135: Kante
- 140: Träger
- 141, 142: Kontaktfläche
- 150: Isolationsmaterial
- 151: Klebstoff
- 155: Aussparung
- 160: Kontaktstruktur
- 170: Ausgangselement
- 171: Vertiefungsstruktur
- 201, 202: Bauelement
- 203, 204: Bauelement
- 205, 206: Bauelement
- 207: Bauelement
- 301, 302: Verfahrensschritt
- 303, 304: Verfahrensschritt
- 305: Verfahrensschritt
- 310: Abstand
- 311: Tiefe
- 400: Halbleiterchip
- 401: Halbleiterschicht
- 402: Halbleiterschicht
- 403: aktive Zone
- 404: Stromaufweitungsschicht
- 405: Isolationsschicht
- 406: Leitfähige Schicht
- 407: Durchgangskontakt
- 408: Trägersubstrat
- 420: Halbleiterchip
- 421: Halbleiterschicht
- 422: Halbleiterschicht
- 423: aktive Zone
- 424: Zwischenschicht
- 425: Trägersubstrat
- 440: Halbleiterchip
- 441: Halbleiterschicht
- 442: Halbleiterschicht
- 443: aktive Zone
- 444: Stromaufweitungsschicht
- 445: Isolationsschicht
- 446: Leitfähige Schicht
- 447: Durchgangskontakt
- 448: Verbindungsschicht
- 449: Trägersubstrat
- 450: metallische Schicht

## Patentansprüche

1. Optoelektronisches Bauelement, aufweisend:
einen Träger (140);
einen auf dem Träger (140) angeordneten ersten optoelektronischen Halbleiterchip (101);
ein auf dem ersten Halbleiterchip (101) angeordnetes erstes Konversionselement (110) zum Konvertieren einer von dem ersten Halbleiterchip (101) abgegebenen Lichtstrahlung;
einen auf dem Träger (140) angeordneten zweiten optoelektronischen Halbleiterchip (102);
ein auf dem zweiten Halbleiterchip (102) angeordnetes zweites Konversionselement (120) zum Konvertieren einer von dem zweiten Halbleiterchip (102) abgegebenen Lichtstrahlung; und
ein auf dem Träger (140) angeordnetes Isolationsmaterial (150), welches den ersten und zweiten Halbleiterchip (101; 102) und das erste und zweite Konversionselement (110; 120) umgibt,
charakterisiert dadurch, dass das erste Konversionselement (110) stufenförmig ausgebildet ist und einen ersten und einen zweiten Abschnitt (111; 112) aufweist, wobei der erste Abschnitt (111) seitlich über den zweiten Abschnitt (112) hervorsteht.

2. Optoelektronisches Bauelement nach Anspruch 1,
wobei das erste und zweite Konversionselement (110; 120) unterschiedliche Dicken aufweisen.

3. Optoelektronisches Bauelement nach Anspruch 1 oder 2,
wobei das erste Konversionselement eine am vorderseitigen Rand des zweiten Abschnitts vorliegende Kante und eine am vorderseitigen Rand des ersten Abschnitts vorliegende zusätzliche Kante (115) aufweist und das Isolationsmaterial im Bereich des ersten Halbleiterchips an der zusätzlichen Kante stoppt.

4. Optoelektronisches Bauelement nach einem der vorhergehenden Ansprüche,
wobei eine Seitenfläche des zweiten Abschnitts (112) frei von dem Isolationsmaterial ist.

5. Optoelektronisches Bauelement nach einem der vorhergehenden Ansprüche,
wobei der erste Abschnitt (111) des ersten Konversionselements (110) über den gesamten Umfang des ersten Konversionselements (110) seitlich über den zweiten Abschnitt (112) hervorsteht.

6. Optoelektronisches Bauelement nach einem der vorhergehenden Ansprüche,
wobei das Isolationsmaterial (150) weißes Silikon ist.

7. Optoelektronisches Bauelement nach einem der vorhergehenden Ansprüche,
wobei der erste und zweite Halbleiterchip (101; 102) jeweils wenigstens einen Vorderseitenkontakt (105) aufweisen, und wobei das optoelektronische Bauelement eine auf dem Isolationsmaterial (150) angeordnete Kontaktstruktur (160) aufweist, welche sich zu wenigstens einem Vorderseitenkontakt (105) erstreckt.

8. Optoelektronisches Bauelement nach einem der vorhergehenden Ansprüche,
wobei der erste und zweite Halbleiterchip (101; 102) ausgebildet sind, eine Lichtstrahlung im blauen Spektralbereich zu erzeugen,
wobei eines der beiden Konversionselemente (110; 120) ausgebildet ist, einen Teil der von einem Halbleiterchip (101; 102) erzeugten Lichtstrahlung in eine Lichtstrahlung im grünen Spektralbereich umzuwandeln,
und wobei das andere der beiden Konversionselemente (110; 120) ausgebildet ist, die von einem Halbleiterchip (101; 102) erzeugte Lichtstrahlung in eine Lichtstrahlung im roten Spektralbereich umzuwandeln.

9. Optoelektronisches Bauelement nach einem der vorhergehenden Ansprüche,
aufweisend mehrere erste Halbleiterchips (101) und hierauf angeordnete erste Konversionselemente (110) und/oder mehrere zweite Halbleiterchips (102) und hierauf angeordnete zweite Konversionselemente (120).

10. Optoelektronisches Bauelement nach einem der vorhergehenden Ansprüche,
weiter aufweisend einen weiteren auf dem Träger (140) angeordneten Halbleiterchip (103) und ein auf dem weiteren Halbleiterchip (103) angeordnetes strahlungsdurchlässiges Element (130).

11. Optoelektronisches Bauelement nach einem der vorhergehenden Ansprüche,
wobei das erste und zweite Konversionselement (110; 120) keramische Konversionselemente sind.

12. Verfahren zum Herstellen eines optoelektronischen Bauelements nach einem der vorhergehenden Ansprüche, umfassend die Verfahrensschritte:
Anordnen eines ersten und zweiten optoelektronischen Halbleiterchips (101; 102) auf einem Träger (140);
Anordnen eines ersten Konversionselements (110) auf dem ersten Halbleiterchip (101) zum Konvertieren einer von dem ersten Halbleiterchip (101) abgegebenen Lichtstrahlung;
Anordnen eines zweiten Konversionselements (120) auf dem zweiten Halbleiterchip (102) zum Konvertieren einer von dem zweiten Halbleiterchip (102) abgegebenen Lichtstrahlung; und
Aufbringen eines Isolationsmaterials (150) auf den Träger (140) derart, dass das Isolationsmaterial (150) den ersten und zweiten Halbleiterchip (101; 102) und das erste und zweite Konversionselement (110; 120) umgibt,
charakterisiert dadurch, dass
das erste, auf dem ersten Halbleiterchip (101) angeordnete Konversionselement (110) stufenförmig ausgebildet ist und einen ersten und einen zweiten Abschnitt aufweist (111; 112), wobei der erste Abschnitt (111) seitlich über den zweiten Abschnitt (112) hervorsteht.

13. Verfahren nach Anspruch 12,
wobei das erste Konversionselement (110) durch Durchführen eines zweistufigen Strukturierungsverfahrens aus einem Ausgangselement (170) erzeugt wird.

14. Verfahren nach einem der Ansprüche 12 oder 13,
wobei der erste und zweite Halbleiterchip (101; 102) jeweils wenigstens einen Vorderseitenkontakt (105) aufweisen,
wobei das auf den Träger (140) aufgebrachte Isolationsmaterial (150) die Vorderseitenkontakte (105) überdeckt,
wobei eine an einen Vorderseitenkontakt (105) heranreichende Aussparung (155) in dem Isolationsmaterial (150) ausgebildet wird,
und wobei nach dem Ausbilden der Aussparung (155) ein metallisches Material unter Auffüllen der Aussparung (155) auf das Isolationsmaterial (150) zum Ausbilden einer Kontaktstruktur (160) aufgebracht wird.

15. Verfahren nach einem der Ansprüche 12 bis 14,
bei dem ein optoelektronisches Bauelement gemäß einem der Ansprüche 1 bis 11 hergestellt wird.

## Claims

1. Optoelectronic component, comprising:
a carrier (140);
a first optoelectronic semiconductor chip (101) arranged on the carrier (140);
a first conversion element (110) arranged on the first semiconductor chip (101) and serving for converting a light radiation emitted by the first semiconductor chip (101);
a second optoelectronic semiconductor chip (102) arranged on the carrier (140);
a second conversion element (120) arranged on the second semiconductor chip (102) and serving for converting a light radiation emitted by the second semiconductor chip (102); and
an insulation material (150) arranged on the carrier (140), said insulation material surrounding the first and second semiconductor chips (101, 102) and the first and second conversion elements (110, 120),
**characterized in that** the first conversion element (110) is embodied in a stepped fashion and has a first and a second section (111; 112), wherein the first section (111) projects laterally beyond the second section (112).

2. Optoelectronic component according to Claim 1,
wherein the first and second conversion elements (110; 120) have different thicknesses.

3. Optoelectronic component according to Claim 1 or 2,
wherein the first conversion element has an edge present at the front-side margin of the second section and an additional edge (115) present at the front-side margin of the first section and the insulation material in the region of the first semiconductor chip stops at the additional edge.

4. Optoelectronic component according to any of the preceding claims,
wherein a side surface of the second section (112) is free of the insulation material.

5. Optoelectronic component according to any of the preceding claims,
wherein the first section (111) of the first conversion element (110) projects laterally beyond the second section (112) over the entire perimeter of the first conversion element (110).

6. Optoelectronic component according to any of the preceding claims,
wherein the insulation material (150) is white silicone.

7. Optoelectronic component according to any of the preceding claims,
wherein the first and second semiconductor chips (101; 102) in each case have at least one front-side contact (105),
and wherein the optoelectronic component comprises a contact structure (160) arranged on the insulation material (150) and extending to at least one front-side contact (105).

8. Optoelectronic component according to any of the preceding claims,
wherein the first and second semiconductor chips (101; 102) are designed to generate a light radiation in the blue spectral range,
wherein one of the two conversion elements (110; 120) is designed to convert part of the light radiation generated by a semiconductor chip (101; 102) into a light radiation in the green spectral range,
and wherein the other of the two conversion elements (110; 120) is designed to convert the light radiation generated by a semiconductor chip (101; 102) into a light radiation in the red spectral range.

9. Optoelectronic component according to any of the preceding claims,
comprising a plurality of first semiconductor chips (101) and first conversion elements (110) arranged thereon and/or a plurality of second semiconductor chips (102) and second conversion elements (120) arranged thereon.

10. Optoelectronic component according to any of the preceding claims,
further comprising a further semiconductor chip (103) arranged on the carrier (140) and a radiation-transmissive element (130) arranged on the further semiconductor chip (103).

11. Optoelectronic component according to any of the preceding claims,
wherein the first and second conversion elements (110; 120) are ceramic conversion elements.

12. Method for producing an optoelectronic component according to any of the preceding claims, comprising the following method steps:
arranging a first and second optoelectronic semiconductor chip (101; 102) on a carrier (140);
arranging a first conversion element (110) on the first semiconductor chip (101) for converting a light radiation emitted by the first semiconductor chip (101);
arranging a second conversion element (120) on the second semiconductor chip (102) for converting a light radiation emitted by the second semiconductor chip (102); and
applying an insulation material (150) to the carrier (140) in such a way that the insulation material (150) surrounds the first and second semiconductor chips (101; 102) and the first and second conversion elements (110; 120),
**characterized in that** the first conversion element (110) arranged on the first semiconductor chip (101) is embodied in a stepped fashion and has a first and a second section (111; 112), wherein the first section (111) projects laterally beyond the second section (112).

13. Method according to Claim 12,
wherein the first conversion element (110) is produced from a starting element (170) by a two-stage structuring method being carried out.

14. Method according to either of Claims 12 and 13,
wherein the first and second semiconductor chips (101; 102) in each case have at least one front-side contact (105),
wherein insulation material (150) applied to the carrier (140) covers the front-side contacts (105),
wherein a cutout (155) extending to a front-side contact (105) is formed in the insulation material (150),
and wherein after the cutout (155) has been formed a metallic material is applied, with the cutout (155) being filled, to the insulation material (150) in order to form a contact structure (160).

15. Method according to any of Claims 12 to 14,
wherein an optoelectronic component according to any of claims 1 to 11 is produced.

## Revendications

1. Composant optoélectronique, possédant :
un support (140) ;
une première puce semiconductrice (101) optoélectronique disposée sur le support (140) ;
un premier élément de conversion (110) disposé sur la première puce semiconductrice (101) pour convertir un rayonnement lumineux délivré par la première puce semiconductrice (101) ;
une deuxième puce semiconductrice (102) optoélectronique disposée sur le support (140) ;
un deuxième élément de conversion (120) disposé sur la deuxième puce semiconductrice (102) pour convertir un rayonnement lumineux délivré par la deuxième puce semiconductrice (102) ; et
un matériau isolant (150) disposé sur le support (140), lequel entoure la première et la deuxième puce semiconductrice (101 ; 102) ainsi que le premier et le deuxième élément de conversion (110 ; 120),
**caractérisé en ce que**
le premier élément de conversion (110) est de configuration étagée et possède une première et une deuxième portion (111 ; 112), la première portion (111) faisant saillie latéralement au-dessus de la deuxième portion (112).

2. Composant optoélectronique selon la revendication 1, les premier et deuxième éléments de conversion (110 ; 120) possédant des épaisseurs différentes.

3. Composant optoélectronique selon la revendication 1 ou 2, le premier élément de conversion possédant une arête présente sur le bord côté avant de la deuxième portion et une arête supplémentaire (115) présente sur le bord côté avant de la première portion, et le matériau isolant s'arrêtant dans la zone de la première puce semiconductrice au niveau de l'arête supplémentaire.

4. Composant optoélectronique selon l'une des revendications précédentes, une surface latérale de la deuxième portion (112) étant exemple du matériau isolant.

5. Composant optoélectronique selon l'une des revendications précédentes, la première portion (111) du premier élément de conversion (110) faisant saillie latéralement au-dessus de la deuxième portion (112) sur tout le pourtour du premier élément de conversion (110).

6. Composant optoélectronique selon l'une des revendications précédentes, le matériau isolant (150) étant du silicone blanc.

7. Composant optoélectronique selon l'une des revendications précédentes, les première et deuxième puces semiconductrices (101 ; 102) possédant respectivement au moins un contact de côté avant (105) et le composant optoélectronique possédant une structure de contact (160) disposée sur le matériau isolant (150), laquelle s'étend en direction d'au moins un contact de côté avant (105).

8. Composant optoélectronique selon l'une des revendications précédentes, les première et deuxième puces semiconductrices (101 ; 102) étant configurées pour générer un rayonnement lumineux dans la plage spectrale du bleu, l'un des deux éléments de conversion (110 ; 120) étant configuré pour convertir une partie du rayonnement lumineux généré par une puce semiconductrice (101 ; 102) en un rayonnement lumineux dans la plage spectrale du vert et l'autre des deux éléments de conversion (110 ; 120) étant configuré pour convertir le rayonnement lumineux généré par une puce semiconductrice (101 ; 102) en un rayonnement lumineux dans la plage spectrale du rouge.

9. Composant optoélectronique selon l'une des revendications précédentes, possédant plusieurs premières puces semiconductrices (101) et premiers éléments de conversion (110) disposés sur celles-ci et/ou plusieurs deuxièmes puces semiconductrices (102) et deuxièmes éléments de conversion (120) disposés sur celles-ci.

10. Composant optoélectronique selon l'une des revendications précédentes, possédant en outre une puce semiconductrice supplémentaire (103) disposée sur le support (140) et un élément transparent au rayonnement (130) disposé sur la puce semiconductrice supplémentaire (103).

11. Composant optoélectronique selon l'une des revendications précédentes, les premier et deuxième éléments de conversion (110 ; 120) étant des éléments de conversion en céramique.

12. Procédé de fabrication d'un composant optoélectronique selon l'une des revendications précédentes, comprenant les étapes de procédé suivantes :
disposition d'une première et d'une deuxième puce semiconductrice (101 ; 102) optoélectronique sur un support (140) ;
disposition d'un premier élément de conversion (110) sur la première puce semiconductrice (101) pour convertir un rayonnement lumineux délivré par la première puce semiconductrice (101) ;
disposition d'un deuxième élément de conversion (120) sur la deuxième puce semiconductrice (102) pour convertir un rayonnement lumineux délivré par la deuxième puce semiconductrice (102) ; et
application d'un matériau isolant (150) sur le support (140) de telle sorte que le matériau isolant (150) entoure la première et la deuxième puce semiconductrice (101 ; 102) ainsi que le premier et le deuxième élément de conversion (110 ; 120),
**caractérisé en ce que**
le premier élément de conversion (110), disposé sur la première puce semiconductrice (101), est de configuration étagée et possède une première et une deuxième portion (111 ; 112), la première portion (111) faisant saillie latéralement au-dessus de la deuxième portion (112).

13. Procédé selon la revendication 12, le premier élément de conversion (110) étant produit à partir d'un élément initial (170) en mettant en oeuvre un procédé de structuration en deux étapes.

14. Procédé selon l'une des revendications 12 ou 13, les première et deuxième puces semiconductrices (101 ; 102) possédant respectivement au moins un contact de côté avant (105), le matériau isolant (150) appliqué sur le support (140) recouvrant les contacts de côté avant (105), une cavité (155) s'étendant jusqu'au bord d'un contact de côté avant (105) étant formée dans le matériau isolant (150) et, après la formation de la cavité (155), un matériau métallique étant appliqué sur le matériau isolant (150) en remplissant la cavité (155) en vue de former une structure de contact (160).

15. Procédé selon l'une des revendications 12 à 14, avec lequel est fabriqué un composant optoélectronique selon l'une des revendications 1 à 11.
